# FASCICULE DE BREVET EUROPEEN

(11) **EP 2 335 037 B1**
(45) Date de publication et mention de la délivrance du brevet: **11.12.2019**
(21) Numéro de dépôt: 09755972.8
(22) Date de dépôt: 06.10.2009
(51) Int. Cl.: G01J 5/20, H01L 31/0203

(54) **DETECTEUR DE RAYONNEMENT ELECTROMAGNETIQUE A MICROENCAPSULATION ET DISPOSITIF POUR LA DETECTION DE RAYONNEMENT ELECTROMAGNETIQUE METTANT EN OEUVRE DE TELS DETECTEURS**
DETEKTOR FÜR ELEKTROMAGNETISCHE STRAHLUNG MIT MIKROEINKAPSELUNG UND EINRICHTUNG ZUM DETEKTIEREN VON ELEKTROMAGNETISCHER STRAHLUNG UNTER VERWENDUNG SOLCHER DETEKTOREN
ELECTROMAGNETIC RADIATION DETECTOR WITH MICRO-ENCAPSULATION, AND DEVICE FOR DETECTING ELECTROMAGNETIC RADIATION USING SUCH DETECTORS

(30) Priorité: 07.10.2008 FR 0856790
(43) Date de publication de la demande: 22.06.2011
(73) Titulaire: LYNRED, 91120 Palaiseau (FR)
(72) Inventeur: VILAIN, Michel, F-38450 Saint Georges de Commiers (FR)
(74) Mandataire: Cabinet Laurent & Charras
(86) Numéro de dépôt international: PCT/FR2009/051901
(87) Numéro de publication internationale: WO 2010/040945

(56) Documents cités:
- EP-A- 1 243 903
- WO-A1-2007/000172
- US-B1- 6 410 916
- US-B1- 6 690 014

## Description

### DOMAINE DE L'INVENTION

La présente invention a trait au domaine de la détection de rayonnements électromagnétiques, et plus précisément de l'imagerie et de la pyrométrie thermique. Plus particulièrement, la présente invention concerne un dispositif pour la détection d'un rayonnement infrarouge, comportant une matrice de détecteurs thermiques élémentaires.

### ETAT ANTERIEUR DE LA TECHNIQUE

Dans le domaine des détecteurs mis en œuvre pour l'imagerie ou la thermographie (pyrométrie) infrarouge, il est connu d'utiliser des dispositifs agencés sous forme matricielle, susceptibles de fonctionner à température ambiante, lesquels utilisent la variation d'une grandeur physique d'un matériau ou assemblage de matériaux approprié(s), en fonction de la température, au voisinage de 300K, c'est-à-dire sans refroidissement. Dans le cas particulier des détecteurs bolométriques, les plus couramment utilisés, cette grandeur physique est la résistivité électrique. D'autres grandeurs électriques peuvent être exploitées, comme la constante diélectrique, la polarisation... voire des grandeurs non électriques, telles des différentiels de dilatation thermique, l'indice de réfraction, etc. Ces détecteurs sont appelés génériquement détecteurs thermiques, par opposition aux détecteurs quantiques (photoconducteurs ou photovoltaïques), lesquels ne fonctionnent de manière optimale qu'aux très basses températures.

Un tel détecteur non refroidi, considéré dans son ensemble prêt à exploiter, est habituellement obtenu par l'assemblage des éléments suivants :
- un substrat comportant des moyens d'adressage matriciel des éléments sensibles (bolomètres élémentaires) et de formation d'un signal électrique à partir de chaque élément. Ce substrat est communément appelé « circuit de lecture » (ou ROIC pour l'expression anglo-saxonne « *Read-Out Integrated Circuit* »). Ce substrat supporte en surface un ensemble matriciel de structures sensibles, essentiellement formées chacune d'une membrane maintenue en suspension au moyen de bras très fins et étroits ;
- une enceinte hermétique (ou boîtier) habituellement sous très faible pression, munie en face éclairée d'une fenêtre transparente aux rayons à détecter, et de connexions électriques destinées au brochage externe du dispositif. Le « vide » est destiné à maintenir une isolation thermique élevée entre le substrat et les éléments sensibles. Cette résistance thermique, fondamentale pour conférer une sensibilité élevée au détecteur, est définie par la forme et les matériaux des bras de suspension.

Le substrat muni des éléments sensibles est intégré par collage ou brasage dans la cavité interne du boîtier en regard de la fenêtre, les connexions électriques du substrat sont reportées aux entrées / sorties internes du boîtier par « *bonding* » filaire. Par ailleurs, ce boîtier contient :
- un élément « getter » activé électriquement ou thermiquement, destiné à maintenir sur la durée de vie du composant un niveau de vide adéquat après pompage initial et fermeture hermétique ;
- un dispositif à effet Peltier (ou TEC pour l'expression anglo-saxonne « *Thermoelectric Cooler* ») capable d'assurer la régulation thermique du substrat, inséré par collage ou brasage entre l'embase du boîtier et le substrat. La mise en œuvre de ce module est destinée à éliminer les effets des variations de température du plan focal lors de la mise en œuvre du détecteur ; de nos jours seuls les composants haut de gamme en sont pourvus.

Pour obtenir une scène par l'intermédiaire de ce détecteur, on projette la scène à travers une optique adaptée sur la matrice de détecteurs élémentaires, et des stimuli électriques cadencés sont appliqués par l'intermédiaire du circuit de lecture à chacun des détecteurs élémentaires, ou à chaque rangée de tels détecteurs, afin d'obtenir un signal électrique analogique ou/et numérique de type vidéo, représentatif de la température atteinte par chacun desdits détecteurs élémentaires et destiné par exemple à la formation d'une image thermique de la scène observée.

Des composants relativement simplifiés par rapport à la description précédente sont fabriqués de nos jours, par l'assemblage de deux pièces formées à partir de deux substrats différents, à l'aide typiquement de techniques dites « *Wafer Level Packaging* » (WLP). Le document WO 95/17014 ou encore le document WO2007/000172 décrivent un objet et une méthode d'élaboration de ce type. On obtient ainsi dans un premier temps l'enceinte sous vide intégrant un getter formé en couche mince, et limitée par les deux éléments de substrat et un cordon de scellement périphérique. L'un des substrats comporte le circuit de lecture et les éléments sensibles, l'autre constitue la fenêtre.

L'intérêt principal de ce type de technique tient au fait qu'un grand nombre de composants hermétiquement scellés peuvent être obtenus simultanément, à l'aide d'un nombre relativement restreint d'éléments et d'opérations, d'où un gain de coût. L'interfaçage avec le milieu extérieur des composants après singulation par découpe mécanique des deux substrats est en principe obtenu dans un second temps à l'aide de l'intégration de l'ensemble unitaire sur une embase relevant par exemple des techniques du circuit imprimé (ou PCB pour l'expression anglo-saxonne « *Printed Circuit Board* ») muni de pistes métalliques standard, qui peut aussi comporter une circuiterie électronique de proximité.

Il demeure cependant une relative complexité du processus global d'élaboration de l'enceinte sous vide, y compris au niveau de la découpe finale, qui ne peut pas s'exercer sur les deux substrats simultanément, car il convient d'exposer hors de l'enceinte les connexions électriques d'entrées / sorties formées sur le substrat du circuit de lecture. L'usage de deux substrats différents nécessite également la mise en œuvre de multiples techniques propres à chaque substrat pour l'obtention des divers caractères nécessaires à leur fonctionnement. Il est nécessaire, par exemple pour le substrat constituant les fenêtres, de former des cavités très planes en regard de chaque matrice sensible, et d'y déposer des couches antireflet localisées. Par ailleurs, les deux substrats doivent comporter des métallisations multicouches destinées au brasage des substrats entre eux. Toutes ces techniques sont maîtrisables mais nécessitent de nombreux équipements dispendieux. De plus, il est nécessaire de maîtriser des technologies de brasage de substrats de grande surface de manière collectivement hermétique au niveau de chaque composant final, ce qui impose des contraintes particulières en termes de planéité et qualité géométrique des deux surfaces à assembler. Enfin, ces opérations sont menées alors que les éléments sensibles extrêmement fragiles sont exposés en surface du substrat circuit de lecture, cette opération étant particulièrement délicate en termes d'intégrité des structures et de risques de contamination particulaire.

Ces techniques représentent donc sans doute un progrès en termes industriels, mais restent cependant relativement complexes et onéreuses.

Une manière de pallier en partie ces limitations est décrite dans le document FR 2 822 541. Celui-ci décrit un objet comportant des microcavités formées en regard de chaque site de détection, à l'aide de techniques micro-électroniques collectives, ainsi que le processus d'élaboration applicable pour aboutir à la mise sous vide fonctionnelle. Selon ces enseignements, il n'y a plus besoin d'un second substrat, ce qui de fait élimine les difficultés propres aux techniques « WLP », limite le nombre d'opérations et le besoin de techniques diversifiées. Par ailleurs la vulnérabilité des structures et la contamination particulaire en cours d'élaboration, c'est-à dire les pertes de rendement associées ou le coût des précautions nécessaires pour les éviter, peuvent être considérés comme nuls.

Cependant, la construction des microcapsules ou microcavités implique d'une part une perte de place sur l'emprise totale de chaque détecteur élémentaire, avec un impact sur la sensibilité finale du composant en raison de la diminution de facteur de remplissage (ou « *Fill Factor* »)*,* lequel se rapporte (de manière simplifiée) à la surface de la membrane sensible par rapport à la surface p², où p désigne le pas de répétition matricielle des éléments unitaires (pixels) de l'imageur thermique. Par ailleurs, les structures d'ancrage des bras de soutien de chaque membrane doivent être inscrites (formées) strictement à l'intérieur de la surface interne délimitée par les cloisons qui séparent chaque microcapsule de ses voisines. Il en résulte une perte de sensibilité liée à la limitation de longueur réalisable desdits bras, laquelle longueur définit la résistance thermique entre la membrane et le substrat. Or la résistance thermique est le facteur clé de la sensibilité des détecteurs thermiques.

Le document EP1 243 903 décrit un réseau de microbolomètres encapsulés dans des cellules élémentaires définies par des cloisons latérales, une fenêtre et un substrat.

Ces inconvénients ne sont pas notoirement pénalisants lorsque le pas de matriçage est relativement confortable, typiquement jusqu'à 35 ou 30 micromètres, voire 25 micromètres. Cependant, le besoin aujourd'hui se fait sentir de produire des matrices d'imagerie spatialement résolues à l'extrême, vers 20 micromètres, voire 15 micromètres de pas, essentiellement sans perte de sensibilité du bolomètre élémentaire. Il est donc nécessaire de concevoir des structures capables d'aboutir à ce résultat, en conservant les avantages industriels des techniques antérieures.

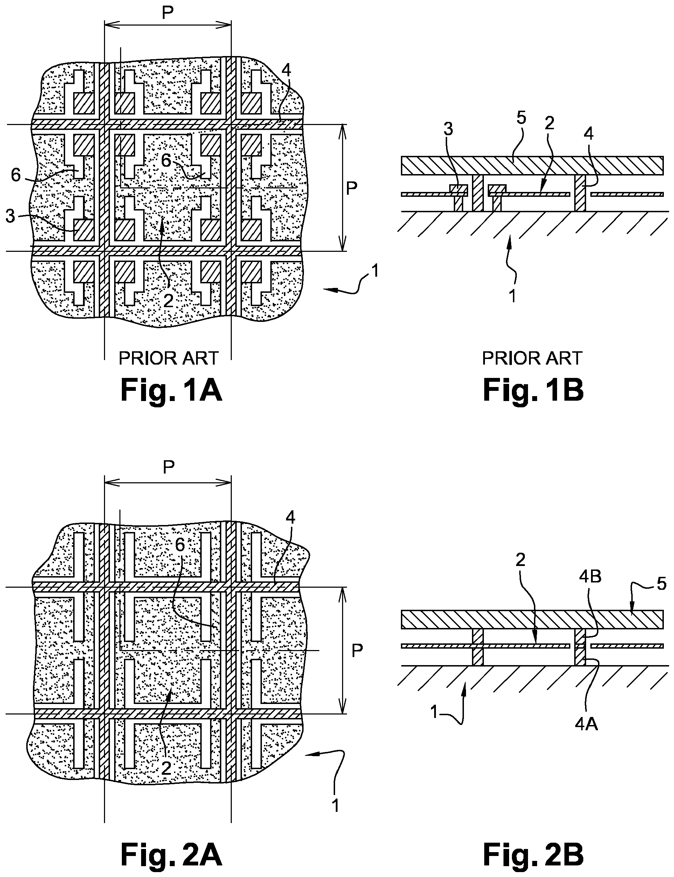

On a décrit en relation avec les figures 1A et 1B le principe sous-tendant les enseignements de ce document.

Ainsi, la figure 1A illustre schématiquement une vue partielle en plan d'une matrice de détecteurs, en négligeant les particularités destinées à l'évacuation et au scellement hermétique des microsites.

L'objet présente :
▪ un substrat initial **1** à partir duquel est formé collectivement l'ensemble des structures ; ce substrat comporte en surface les éléments électroniques nécessaires au fonctionnement du dispositif, il n'est pas utile de détailler ce point ;
▪ les membranes sensibles **2,** matricées au pas de répétition p, soutenues par leurs bras de maintien **6** ;
▪ des structures d'ancrage **3** sur lesquelles s'appuient les extrémités des bras **6** ;
▪ des parois ou cloisons périphériques **4** des microcapsules, qui séparent les microsites de détection ;
▪ les capots supérieurs ou fenêtres **5,** essentiellement transparentes, qui ferment les microcapsules en s'appuyant sur l'extrémité supérieure des parois **4.**

La figure 1B complète la description en section établie selon le tracé pointillé de la figure 1A. Il n'est nul besoin de détailler plus avant la construction ou la géométrie de ces éléments, il convient cependant de préciser les ordres de grandeur de la géométrie d'ensemble.

L'espace entre le substrat et les membranes est typiquement voisin de 2 micromètres de manière à optimiser la sensibilité dans la bande infrarouge usuelle entre 8 et 14 micromètres de longueur d'onde, moyennant la formation d'un réflecteur (non représenté) en surface du substrat, comme cela est bien connu. L'espace entre les membranes **2** et la fenêtre **5** est aussi typiquement de l'ordre de 2 micromètres de manière à éviter une trop grande proximité des éléments une fois la cavité évacuée. Le pas p d'une telle structure est typiquement supérieur à 25 micromètres.

Il apparait que l'emprise des structures d'ancrage **3,** au nombre de quatre sur la figure 1A, et éventuellement réductible à deux si la stabilité mécanique des membranes le permet, limite sensiblement l'énergie radiative que peut efficacement capter chaque membrane **2** en proportion de l'énergie totale que reçoit la surface p².

Par ailleurs, l'emprise des parois **4** et l'espace adjacent périphérique à l'intérieur des microcapsules entre les parois **4** et les membranes **2** limitent aussi partiellement l'énergie radiative captable par la membrane.

En d'autres termes, ces considérations géométriques se traduisent par une limitation sensible du facteur de remplissage, en particulier pour les pas les plus réduits.

Il apparait une autre limitation manifeste au niveau de la longueur du bras de soutien **6** réalisable avec des structures d'ancrage inscrites à l'intérieur des parois, en comparaison de structures certes dépourvues de microcapsules, mais dotées de points d'ancrage communs à deux (voire quatre) membranes adjacentes. Cette disposition avantageuse, obtenue en formant les points d'ancrage sur l'axe de symétrie entre deux (ou quatre) sites sensibles, est usuelle dans le domaine selon la technique habituelle dépourvue de microcapsules, et établit de fait le niveau de performance de la technique connue.

L'invention a donc pour but de proposer de telles structures et leurs méthodes d'élaboration pour former en final des détecteurs bénéficiant de la meilleure performance, tout en bénéficiant des avantages apportés par la technique des microsites hermétiques.

Un autre but de l'invention est de proposer des dispositifs particuliers ainsi que leur méthode d'élaboration, dotés de caractéristiques électro-optiques avantageusement obtenues dans le cadre de l'invention :
- des détecteurs dotés de microsites sensibles respectivement dans plusieurs bandes spectrales,
- des détecteurs dotés localement de microsites de référence insensibles au rayonnement IR,
- des détecteurs dotés de la capacité de ne détecter que certaines orientations de polarisation ou d'incidence du rayonnement, ou encore disposant d'un filtre passe haut pixellique uniforme ou distribué selon plusieurs longueurs d'onde de coupure,
- des détecteurs dotés d'une fonction de protection contre les rayonnements intenses.

L'invention est le plus souvent détaillée dans la suite de la description selon des détails d'architecture adaptés au cas particulier d'intérêt le plus courant de détection dans l'infrarouge « long » (*LWIR* en anglais), correspondant à la fenêtre de transmission atmosphérique entre 8 et 14 micromètres. Cependant, il est possible d'adapter les détails de construction de manière à exploiter l'invention dans d'autres bandes infrarouges, voire au-delà, dans le domaine dit « Terahertz ». C'est pourquoi le terme de « rayonnement électromagnétique » est parfois utilisé de préférence au limitatif « infrarouge ».

Par ailleurs, dans la suite de la description, il doit être entendu par les expressions « rayonnement d'intérêt », ou plus précisément « bande spectrale d'intérêt », dont les limites sont dénommées par la suite λmin et λmax, la plage de longueurs d'onde pour laquelle le détecteur est destiné à (conçu pour) être sensible. Dans le cas des microbolomètres, la membrane en elle-même est habituellement sensible sur une très large plage de rayonnements (en d'autres termes, très peu sélective en longueurs d'onde), il s'ensuit que la « bande spectrale d'intérêt » est de fait définie par le spectre sur lequel la fenêtre (ici, le capot fenêtre) est essentiellement transparente.

Il doit également être entendu sous l'expression « sensibilité spectrale préférentielle » ou « spectre préférentiel » l'obtention d'un maximum de sensibilité (ou réponse optique) du détecteur autour d'une longueur d'onde particulière λp à l'intérieur de ladite bande spectrale d'intérêt, au moyen d'un gabarit de transmission spectrale du capot fenêtre qui présente un maximum au voisinage de cette longueur d'onde.

### EXPOSE DE L'INVENTION

A cet effet, l'invention a pour objet une constitution particulière des parois de microcapsules hermétiques et des points d'ancrage des bras de soutien des membranes constitutives des détecteurs élémentaires, se traduisant par l'effacement substantiel des limitations de l'art antérieur.

Ainsi, l'invention vise-t'elle un détecteur de rayonnement électromagnétique destiné à fonctionner autour d'une longueur d'onde préférentielle λp comprise dans une bande spectrale d'intérêt définie entre λmin et λmax, constitué d'une pluralité de microsites de détection élémentaires comprenant chacun un micro-détecteur muni d'une membrane sensible au rayonnement au moins dans la bande spectrale d'intérêt, et reçu chacun dans une microcavité ou microcapsule définie par un substrat, par une paroi supérieure faisant fonction de fenêtre transparente audit rayonnement dans la bande spectrale d'intérêt pour une partie au moins de ladite pluralité de microsites, et par des cloisons latérales, ladite membrane étant suspendue au dessus du substrat au moyen d'au moins deux bras de soutien comportant une couche électriquement conductrice ; à l'intérieur de chacune des microcavités ou microcapsules règne typiquement le vide ou une faible pression.

Il est retenu pour la suite le qualificatif « hermétique » de préférence aux notions appelant les termes « vide » ou une quelconque pression, du fait que la caractéristique essentielle des microcapsules est leur aptitude à maintenir sur toute la durée de vie opérationnelle du produit final (plusieurs années), et en tenant compte de la présence préférentielle d'un élément getter en communication avec la cavité, une pression interne suffisamment stable pour ne pas perturber le fonctionnement des éléments sensibles qui y sont logés. Ainsi, même si en général il sera recherché une pression typiquement inférieure à 5. 10⁻³ mbar, entendue ordinairement comme « le vide », une pression interne beaucoup plus élevée d'un gaz à faible conductivité thermique (Ar, Xe, Kr) peut répondre à l'unique exigence de durée de vie, mais implique l'herméticité au sens ci-dessus précisé.

Selon l'invention :
- les extrémités desdits bras de soutien sont ancrées dans les cloisons latérales ;
- les cloisons latérales définissant lesdites microcavités ou microcapsules sont constituées de deux parties intimement jointes :
   - une première partie inférieure, adhérente au substrat, formant soubassements mitoyens des cloisons périphériques à chaque microsite de détection, et comprenant localement des connexions verticales conductrices de l'électricité en continuité électrique avec la couche électriquement conductrice des bras de soutien ;
   - une seconde partie, dont la base est superposée et solidairement jointe au sommet de ladite première partie sur la périphérie de chaque microcapsule, et supportant la paroi supérieure ou fenêtre, laquelle est essentiellement parallèle au substrat.

Par ailleurs, la continuité électrique entre les au moins deux bras de soutien comportant une couche électriquement conductrice et le substrat est réalisée par conduction s'étendant transversalement par rapport à l'axe desdits bras au niveau du plan de jonction entre les deux parties des cloisons latérales jusqu'à aboutir à un élément de connectique verticale (16) en conduction électrique avec ledit substrat.

Selon une caractéristique de l'invention, les ancrages et les connexions électriques des extrémités des bras de soutien des membranes sont formés aux interfaces entre ces deux parties. De ce fait les pertes de sensibilité inhérentes selon les détecteurs de l'art antérieur à la limitation de longueur des bras ainsi qu'à l'emprise des points d'ancrage, sont substantiellement annulées.

Selon une caractéristique avantageuse de l'invention, on ménage des facettes périphériques au niveau des parois supérieures ou fenêtres, au voisinage des cloisons latérales, de manière à compenser pour l'essentiel les pertes résiduelles de facteur de remplissage dues à l'emprise des dites cloisons. Plus précisément, ces facettes périphériques, inclinées en direction du substrat ou de profil arrondi, sont aptes à dévier l'essentiel du rayonnement électromagnétique incident au voisinage des frontières entre deux microsites vers l'une ou l'autre des microcavités adjacentes, et ce, essentiellement sans perte intermédiaire en termes de signaux pour la formation d'image.

Avantageusement, le substrat est revêtu d'une couche faisant fonction de réflecteur du rayonnement incident en direction des membranes sensibles, ledit réflecteur étant constitué en totalité ou en partie d'un matériau apte à capter les molécules résiduelles de gaz piégées dans les microcapsules ou getter, par exemple constitué par du titane.

Avantageusement, le détecteur de l'invention est exempt de toute structure d'ancrage des bras de soutien des membranes sensibles autre que les cloisons latérales définissant les microcapsules ou microcavités.

Avantageusement, le scellement hermétique des microcavités est formé de matériaux adhérents à, ou constitutifs de la paroi supérieure ou fenêtre et qui reposent solidairement sur des éléments disposés localement en dessous des fenêtres et ancrés latéralement dans la partie supérieure des cloisons latérales.

Les techniques destinées à permettre l'évacuation des matériaux sacrificiels emprisonnés temporairement à l'intérieur des microcapsules ou microcavités, et celles de fermeture hermétique des dites microcapsules sont enseignées par exemple dans le document FR 2 822 541, et de manière plus pratique dans le document FR 2 864 340. Des dispositions avantageuses car particulièrement adaptées à ce contexte seront indiquées lors de l'exposé détaillé de l'invention.

Dans le cadre d'une application spécifique de l'invention, les microdétecteurs sont constitués de microbolomètres, et la paroi supérieure ou fenêtre des microcapsules est réalisée en un matériau choisi dans le groupe comprenant le silicium, les alliages de silicium et de germanium, le sulfure de zinc, en couche unitaire ou en multicouche.

Selon un mode particulier de réalisation, une première partie des microsites présente un spectre préférentiel substantiellement différent du spectre préférentiel d'une seconde partie des microsites, au moyen de la formation d'au moins une couche différente dans ou sur la fenêtre de l'une des dites parties par rapport à l'autre partie.

Selon un autre mode particulier de réalisation, une première partie des microsites est sensible au rayonnement d'intérêt, alors qu'une seconde partie des microsites, est essentiellement aveugle, au moyen d'une couche métallique opaque disposée dans ou sur la fenêtre de la seconde partie.

Selon un autre mode particulier de réalisation, une partie au moins des microsites est sensible à la polarisation, ou à l'angle d'incidence du rayonnement incident, au moyen d'un réseau de conducteurs disposés dans ou sur la fenêtre de ladite partie.

Selon un autre mode particulier de réalisation, une première partie des microsites comporte une microcavité hermétique, alors que la cavité interne d'une seconde partie des microsites est en communication avec l'atmosphère externe à la microcapsule.

Selon un autre mode particulier de réalisation, une première partie des microsites comporte une microcavité hermétique, alors que le volume interne d'une seconde partie des microsites, est entièrement comblée de matière.

Selon un autre mode particulier de réalisation, le détecteur est pourvu d'un filtre passe haut au moyen de la formation d'au moins une couche particulière dans la fenêtre.

Selon un mode particulier de réalisation, une première partie des microsites est pourvue d'un premier filtre passe haut, et au moins une seconde partie est dotée d'un second filtre passe haut. En d'autres termes, une première partie des microsites est pourvue d'un filtre passe haut selon une première longueur d'onde de coupure, et au moins une seconde partie des microsites est pourvue d'un filtre passe haut selon au moins une seconde longueur d'onde de coupure.

Selon enfin encore un autre mode particulier de réalisation, une partie au moins des microsites comporte au moins une couche formée dans ou sur la fenêtre, qui confère au détecteur une sensibilité variable en fonction du flux électromagnétique incident.

L'invention concerne également un dispositif pour la détection de rayonnements électromagnétiques mettant en œuvre de tels détecteurs.

### BREVE DESCRIPTION DES FIGURES

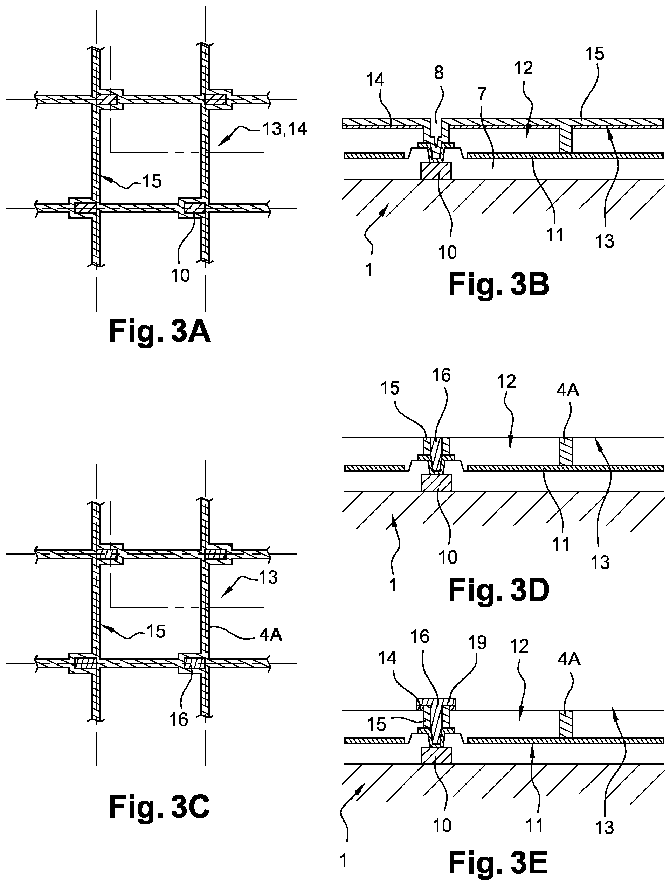

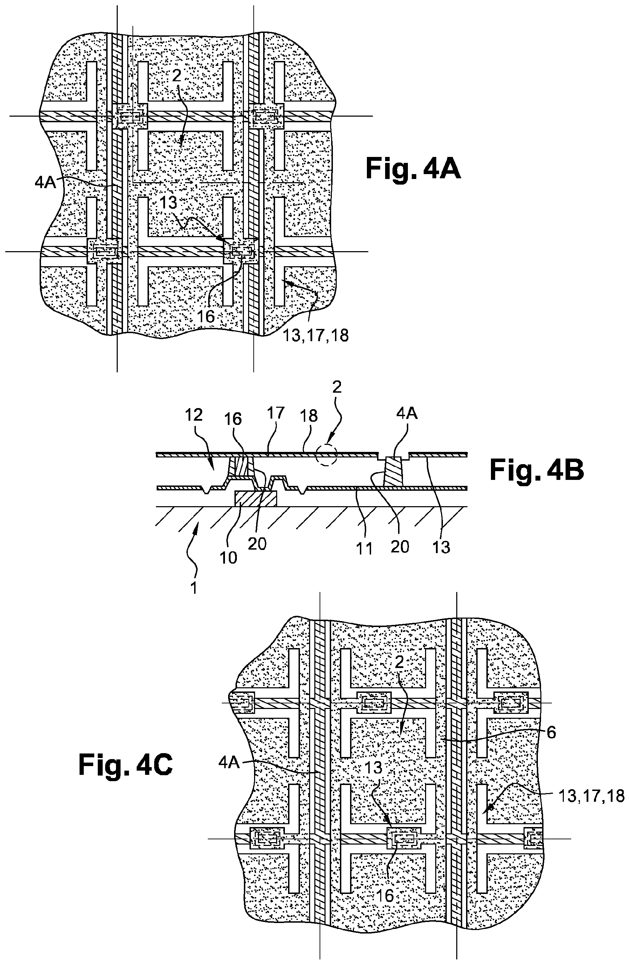

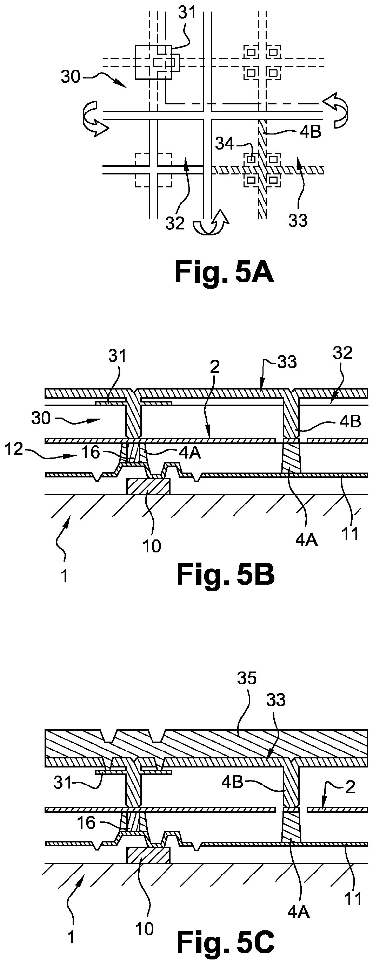

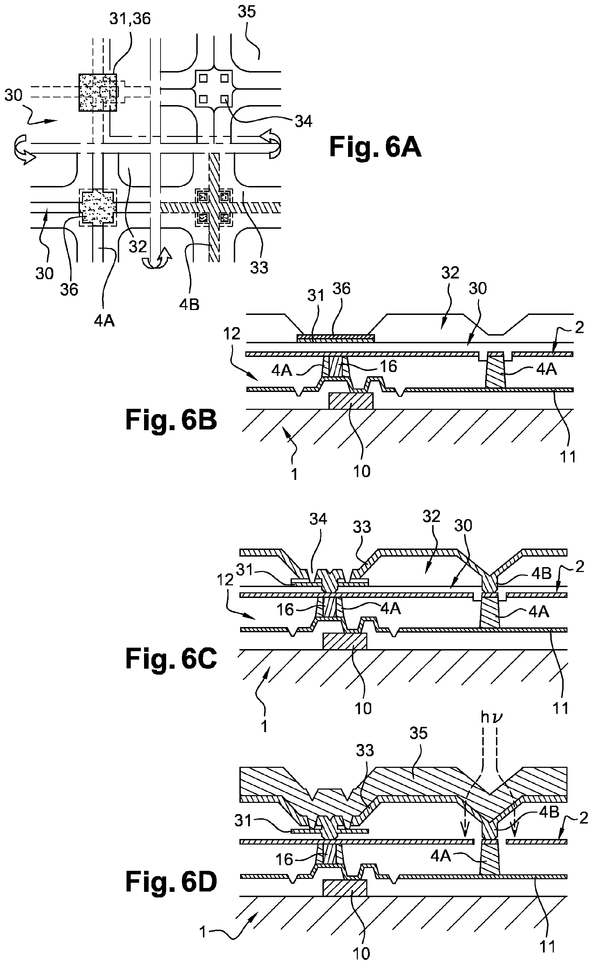

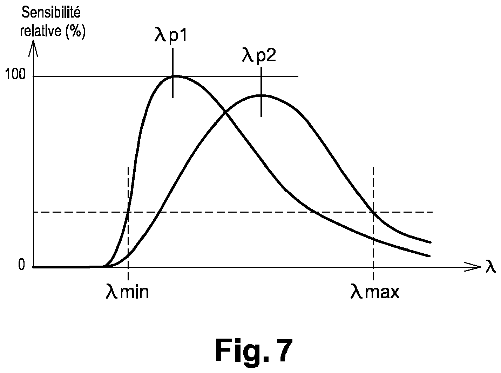

L'invention sera bien comprise à la lecture de la description qui suit, dont les détails sont donnés uniquement à titre d'exemple, et produite en relation avec les figures annexées, dans lesquelles des références identiques se rapportent à des éléments identiques :
▪ la figure 1A représente une vue partielle de principe en plan d'un champ matriciel de microcapsules selon l'état antérieur de la technique, de manière générique ;
▪ la figure 1B représente l'objet de la figure 1A, selon une section verticale simplifiée aux éléments essentiels ;
▪ la figure 2A est une vue partielle de principe en plan d'un champ matriciel de micro-capsules selon l'invention, et selon un assemblage simplifié pour la clarté de l'exposé;
▪ la figure 2B représente une vue en section de la structure de la figure 2A, selon le tracé pointillé, simplifiée aux éléments essentiels ;
▪ les figures 3A et 3C représentent une vue partielle en plan d'un champ matriciel de microcapsules selon l'invention, et selon un premier mode de formation des cloisons, à deux stades d'élaboration ;
▪ les figures 3B et 3D représentent respectivement les vues en section de la structure en relation avec les figures 3A et 3C ;
▪ la figure 3E représente la même vue en section selon une variante de formation des connexions électriques ;
▪ la figure 4A représente une vue partielle en plan d'un champ matriciel de microcapsules selon l'invention, selon un second mode de formation des cloisons, ceci après l'étape de formation des membranes constitutives des détecteurs ;
▪ la figure 4B représente une vue en section de la structure de la figure 4A ;
▪ la figure 4C représente une vue partielle en plan d'un champ matriciel de microcapsules selon l'invention, selon un mode particulier d'insertion des bras à finalité électrique, après l'étape de formation des membranes constitutives des détecteurs ;
▪ la figure 5A représente une vue partielle en plan d'un champ matriciel de microcapsules selon l'invention, et selon un mode préférentiel de formation des parties supérieures des cloisons et capots des microcapsules, et à divers stades d'élaboration ;
▪ les figures 5B et 5C représentent des vues en section de la structure de la figure 5A selon le tracé pointillé, à deux stades de formation des dites structures ;
▪ la figure 6A représente une vue partielle en plan d'un champ matriciel de microcapsules selon l'invention, et selon un mode alternatif avantageux de formation des parties supérieures des cloisons et capots de microcapsules, à divers stades d'élaboration ;
▪ les figures 6B à 6D représentent des vues en section de la structure de la figure 6A, à trois stades de formation des dites structures ;
▪ la figure 7 est un graphe représentatif d'une double sensibilité d'un détecteur conforme à l'invention à deux longueurs d'onde préférentielles.

Par souci de clarté des illustrations, sur les vues en plan seules les limites des couches superposées nécessaires à une compréhension suffisante du texte en relation sont indiquées, de manière exemplative. Les vues en section sont aussi explicites que nécessaire, de nouveau de manière purement exemplative, étant entendu que d'autres formes ou détails peuvent être conférés aux divers matériaux suggérés sans sortir du champ de la présente invention.

Il convient également d'entendre que le terme « une couche » peut s'entendre par « une ou plusieurs couches » selon que la technique le nécessiterait au niveau du détail de construction, sans que le principe exposé s'en trouve modifié ni étendu sur le fond. Cette précision s'applique aussi aux développements fournis en éclairage des divers modes particuliers de réalisation.

### DESCRIPTION DETAILLEE DE L'INVENTION

La figure 2A illustre schématiquement une construction selon l'invention, selon une forme dépouillée des éléments fonctionnels de connectique électrique, évacuation et scellement hermétique des microsites. Les éléments se détaillent comme suit :
▪ le substrat initial **1** à partir duquel est formé collectivement l'ensemble des structures ;
▪ les membranes sensibles **2** des détecteurs matricées au pas de répétition p, soutenues par leurs bras de maintien **6,** qui s'étendent jusqu'aux parois périphériques **4** dans lesquelles ils s'insèrent ;
▪ les parois ou cloisons latérales **4** formées des parties **4A** et **4B** superposées ;
▪ les capots supérieurs ou fenêtres **5.**

La figure 2B complète la description au niveau de l'insertion des bras de soutien **6** des membranes **2.** Les structures d'ancrage selon leur forme traditionnelle schématisée sur les figures 1A et 1B disparaissent, et les bras **6** s'étendent jusqu'au joint des deux parties **4A** et **4B** des parois **4** qui jouent de fait le rôle de structures d'ancrage, formées sur l'axe de symétrie entre sites sensibles, comme il est usuel selon la technique connue la plus performante. Il en résulte un gain substantiel de résistance thermique, donc de sensibilité du détecteur en regard de la technique décrite dans le document FR 2 822 541. De même, l'élimination de l'emprise des structures d'ancrage **3** selon la figure 1A, et des espaces de séparation associés fournit un gain de facteur de remplissage non négligeable. Cette disposition devient presque (à l'emprise des parois près) équivalente aux dispositifs habituels dépourvus de microcapsules, mais avantageusement munis de connexions et points d'ancrage chacun partagés entre deux sites de détection, voire même quatre sites, comme l'homme de métier peut l'imaginer facilement.

Il résulte clairement de la constitution du détecteur selon l'invention, qu'il devient possible de construire des détecteurs thermiques selon un pas de matriçage de l'ordre de 25 micromètres, voire jusqu'à la limite physique utile dans l'infrarouge dit « long » (*LWIR* pour les anglo-saxons) de l'ordre de 15 micromètres, au prix d'une perte négligeable de sensibilité en comparaison de structures élaborées selon la technique connue, mais dépourvues de microcapsules, c'est-à-dire qui doivent être intégrées selon les techniques classiques avec leurs limitations propres, en particulier économiques, décrites en préambule. En complément, la perte résiduelle liée à l'emprise des parois peut être substantiellement éliminée comme il sera indiqué plus loin.

Le mode de réalisation de ce détecteur selon un premier mode préférentiel non limitatif de formation des cloisons est exposé ci-après en relation avec les figures 3A et 3B.

Le processus commence par le dépôt et la définition par gravure d'une couche métallique réfléchissante **11,** par exemple à base de titane ou/et d'aluminium en surface du substrat **1.** De manière connue, ledit substrat est passivé par un ensemble de couches diélectriques **7** bien connues dans le domaine. La passivation présente localement des ouvertures vers des plots métalliques **10** destinés aux accès électriques vers les membranes sensibles **2.** La couche réfléchissante **11** est destinée à former la partie inférieure de la lame quart d'onde traditionnelle du domaine. De manière avantageuse, comme cela a été déjà proposé, cette couche **11** constitue en partie ou totalité l'élément getter en général utile lorsqu'on cherche à maintenir une faible pression dans les capsules finalement formées.

On poursuit le processus par l'application d'une couche **12** planarisante, typiquement de nature organique comme du polyimide, selon une épaisseur finale de l'ordre de 2 micromètres au niveau de la partie centrale des éléments sensibles.

On dépose ensuite une première couche de matériau diélectrique **13** d'épaisseur typiquement inférieure à 0,1 micromètre, en oxyde ou nitrure de silicium par exemple, puis une couche d'aluminium ou de silicium amorphe **14,** de l'ordre de 0,1 à 0,2 micromètre d'épaisseur, dans laquelle on forme par gravure un réseau de rainures **8** larges d'environ 0,5 micromètre. Cette gravure est poursuivie de manière anisotrope par celle de la couche **12** jusqu'à découvrir les motifs **10** et la surface passivée du substrat. Selon ce mode de réalisation, les rainures présentent une largeur plus importante par exemple d'environ 0,5micromètre au voisinage des motifs **10.** Une couche diélectrique ou de silicium amorphe conforme **15** épaisse d'environ 0,5 à 1 micromètre est ensuite déposée dans ces rainures et en surface de la couche **14,** par les techniques connues en la matière. L'épaisseur de la couche **15** est telle que les rainures sont entièrement remplies dans leurs parties étroites, et laissent une ouverture libre de 0,5 à 1 micromètre dans leurs parties élargies.

La suite de la description s'appuie sur les figures 3C et 3D.

La couche **15** est alors gravée de manière anisotrope de façon à découvrir la couche **14,** ainsi que le fond des parties élargies des rainures, qui débouche sur les contacts **10.** Les rainures, dans leurs parties étroites, restent remplies jusqu'à leur sommet, et le profil vertical des parties élargies reste tapissé de la couche **15.** Les cavités formées par les parties élargies des rainures sont ensuite métallisées à l'aide de techniques connues en microélectronique, qui mettent en œuvre typiquement du tungstène ou siliciure de tungstène par CVD (selon l'expression anglo-saxonne « *Chemical Vapour Déposition* »), ou encore des processus électrochimiques par exemple impliquant du cuivre. Cette métallisation **16** remplit les cavités résiduelles verticales et recouvre la couche **14,** laquelle est ensuite découverte par gravure sans masque de la métallisation **16.** Il ne subsiste alors de cette couche **16** que les éléments verticaux, ainsi qu'on peut bien l'observer sur la figure 3D. La couche **14** est alors elle aussi partout enlevée par gravure sans masque, afin de découvrir de manière sélective la couche **13.**

La couche **14** joue le rôle accessoire d'une part de masque dur (« *hard mask* ») pour la gravure des rainures, et d'autre part de couche d'arrêt pour faciliter l'élimination de la métallisation **16** sans détériorer la couche **13.** Cependant, moyennant la mise en œuvre de procédés très sélectifs il est possible d'éliminer l'usage de cette couche **14.** L'homme du métier dispose des procédés adéquats pour graver cette couche **14,** selon qu'elle est formée d'aluminium ou de silicium comme il a été proposé.

A ce stade les parties inférieures **4A** des parois **4** sont formées, ainsi que les éléments de connexions électriques vers les structures actives des membranes.

Le processus se poursuit par la formation des structures propres à la membrane **2,** qui résulte en l'objet représenté de manière simplifiée selon les figures 4A et 4B.

La figure 4B suppose la mise en œuvre de l'arasement complet des couches **16** et **14** lors des étapes précédentes, selon l'assemblage décrit à l'aide de la figure 3D. Dans ce cas il convient par exemple à ce stade de déposer une couche métallique **17** au dessus de la couche **13,** puis une seconde couche diélectrique **18** essentiellement identique à la couche **13,** de manière à former la matière des bras de soutien **6** selon une conformation connue. La couche **17,** par exemple en nitrure de titane, destinée à assurer la continuité électrique d'au moins deux bras par membrane, est formée en continuité des métallisations verticales **16** déjà décrites, telles que représentées en plan sur la figure 3C.

La continuité électrique des bras vers les contacts **10** peut être réalisée selon la variante proposée en figure 3E (sur laquelle la couche **17** n'est pas représentée dans un souci de simplification). Dans ce cas particulier de réalisation, il convient d'intercaler la couche **17** en séquence entre les couches **13** et **14.** Lors des opérations précédemment décrites de gravure des couches **16** et **14,** qui découvrent dans ce cas la couche **17,** une collerette **19** est conservée au voisinage immédiat des éléments verticaux **16.** La continuité électrique est obtenue selon cette variante de manière plus traditionnelle.

Il n'est pas besoin de détailler la formation des membranes **2,** et notamment le dépôt et la définition d'une ou plusieurs couches sensibles à la température en continuité électrique avec la couche **17,** dont on trouvera des formes de réalisation typiques dans les documents FR 2 752 299 (US 5,912,464) ou FR 2 796 148 (US 6,426,539).

Il convient de noter que selon la nature des matériaux mis en œuvre pour former les membranes, le choix d'en laisser la matière sur les sommets des formations périphériques **4A,** ou au contraire de les supprimer, sera aisément fait par l'homme du métier. Les détails des membranes en plan et coupe n'ont pas lieu d'être précisés, ainsi sur les figures suivantes le contour des membranes en plan n'est pas représenté pour simplifier les figures, et représenté sur les coupes par un trait épais non détaillé quant à sa structure interne.

Il est aisé de former des bras de soutien non destinés à une continuité électrique, c'est à dire à finalité purement mécanique s'il s'en trouve, sans perte de place à l'intérieur des cavités, comme suggéré par la figure 2A, puisque les couches constitutives des bras s'étendent au moins au contact, ou au dessus des parois **4A** ainsi formées. Pour assurer si nécessaire l'insertion des marges de la couche **13** (ou plus généralement, des couches déposées avant gravure des rainures, puis conservées dans la constitution des points d'insertion des bras) dans la cloison **4A,** il est utile de prévoir avant le dépôt de la couche **15** une légère attaque isotrope du matériau sacrificiel **12** par un traitement de courte durée sous plasma d'oxygène par exemple, de manière à élargir quelque peu la rainure sous le bord des couches minérales de surface. Le dépôt ultérieur du remplissage **15** adhère ensuite à la face inférieure périphérique de la couche **13.**

Selon la variante exposée précédemment selon la figure 3D, pour laquelle la couche **17** est déposée après la formation des conducteurs **16,** il est possible par ailleurs de former les points d'appui des bras à finalité électrique en n'importe quel point des cloisons **4A,** pourvu que la couche **17** soit conservée de manière continue au sommet des parois **4A** jusqu'à au moins un élément de connectique verticale **16.**

La figure 4C représente un exemple de disposition particulière exploitant cette possibilité, selon laquelle les éléments **16** sont formés dans le réseau de cloisons **4A** de manière décalée par rapport à l'axe des bras électriques. En effet, l'ancrage des bras de soutien électriques au droit des connexions verticales **16,** proposée sur la figure 4A, n'est qu'un exemple de disposition inspiré de la construction habituelle de l'état de l'art. Ce faisant, l'extension des bras électriques s'en trouve encore augmentée, puisque la rainure ne présente pas dans ce cas d'élargissement au point d'insertion desdits bras. Ainsi sur la figure 4C, la couche **17,** dont il n'y a pas nécessité de représenter les détails au niveau des bras et dans la membrane, est conservée entre les connexions verticales **16** et le point d'ancrage des bras électriques pour assurer la continuité depuis le contact **10** au niveau du substrat jusqu'à la membrane **2.**

En d'autres termes, la continuité électrique entre les bras **6** et le substrat **1** est réalisée par conduction s'étendant transversalement par rapport à l'axe desdits bras au niveau du plan de jonction entre les parties **4A** et **4B** des parois latérales jusqu'à aboutir à l'élément de connectique verticale **16** en conduction électrique avec ledit substrat.

Cette forme particulière de connectique déportée courant au sommet des cloisons **4A** est réalisable également selon la variante exposée en lien avec la figure 3E, en prenant la disposition de conserver la couche **16** non seulement pour former les extensions en collerette **19** déjà décrites, mais aussi selon une extension locale au sommet des parois **4A** selon le principe décrit, depuis la zone métallisée **16** jusqu'au point d'ancrage des bras à finalité électrique

L'homme du métier saura exploiter avantageusement ces particularités, et maintenir ou interrompre la continuité des diverses couches afin d'assurer la connectivité ou l'isolement adéquats entre les connexions nécessaires aux membranes.

Avant de poursuivre la description de l'assemblage, les explications d'élaboration des éléments de cloisons inférieures **4A** selon un second mode préférentiel non limitatif sont exposées maintenant en relation avec les figures 4A et 4B déjà exploitées.

Ce processus commence comme précédemment par le dépôt et la définition du réflecteur **11** en surface du substrat, en continuité avec les contacts **10.** La découpe de détail du motif réflecteur **11** est modifiée par rapport à celles des figures 3B, 3D, 3E mais il ne s'agit que d'une autre forme exemplative sans contingence particulière dans cet exemple, destinée à faciliter la représentation des topographies finales résultant du processus proposé. Une couche de passivation diélectrique **20** épaisse d'environ 2 micromètres, formée des matériaux usuels en la matière, à savoir d'oxyde ou nitrure de silicium ou intermédiaires, est ensuite déposée par les moyens usuels du domaine.

Cette couche **20** est avantageusement planarisée par CMP (selon l'expression anglo-saxonne « *Chemical Mechanical Polishing* »), puis des ouvertures verticales sont pratiquées par gravure anisotrope au travers de cette couche **20,** aux emplacements destinés aux connexions électriques verticales. Une métallisation **16** est déposée partout et en particulier de manière à combler ces ouvertures, selon les techniques dédiées bien connues, typiquement par CVD ou/et dépôt électrochimique.

La couche 16 est enfin arasée jusqu'en surface de la couche 20, typiquement par CMP, technique habituelle du domaine.

Les parties 4A sont ensuite définies par gravure anisotrope de la couche 20 selon le tracé exemplifié sur la figure 5A jusqu'à déboucher en surface du réflecteur 11 qui sert de couche d'arrêt. Les espaces entre motifs 11 apparaissent légèrement en creux à l'issue de cette opération, comme suggéré par la figure 4B, sans effet adverse sur le résultat recherché.

Une couche planarisante **12,** typiquement de polyimide, est ensuite appliquée de manière à combler et grossièrement niveler l'ensemble de la texture superficielle, puis planarisée par gravure ou préférentiellement par CMP, jusqu'à découvrir les surfaces des sommets de structures **4A.** On notera qu'il est possible de ne planariser par CMP la structure qu'une seule fois, à cette étape, si la ou les couches **16** sont laissées en place sur les surfaces horizontales avant l'étape de formation des cavités dans la couche **20.**

Le processus se poursuit par le dépôt de la couche diélectrique **13,** laquelle est ouverte très localement par gravure au voisinage des métallisations **16.** La couche **17** est alors déposée sur la structure de manière à former les continuités électriques avec le sommet des éléments **16.** Après définition selon les besoins fonctionnels des bras et membranes de cette couche **17,** la seconde couche diélectrique **18,** préférentiellement semblable à la couche **13,** est déposée et définie par gravure, puis le processus se poursuit jusqu'à complétion des éléments des bras de soutien et des membranes **2** elles-mêmes, sans qu'il soit nécessaire de détailler ces étapes dans ce contexte.

On obtient de la sorte une construction selon l'invention, de manière avantageuse en termes de complexité en nombre d'étapes, et de topographie pratiquement nulle au sommet des parois **4A,** avec les mêmes caractères de versatilité de connectique et de formation de structures mécaniques optionnelles supportées par les parois périphériques selon l'invention.

Un mode préférentiel de réalisation des parties supérieures **4B** des cloisons, et des capots de fermeture (ou fenêtres) **5** est maintenant décrit en relation avec les figures 5A, 5B, 5C.

La figure 5A est subdivisée en quatre quartiers qui décrivent selon le sens des flèches l'avancement de la construction à quelques étapes caractéristiques selon des vues en plan sur lesquelles seuls les éléments essentiels sont représentés.

Le processus commence par le dépôt d'une couche planarisante **30,** essentiellement de même nature que la couche **12,** selon une épaisseur par exemple de 2 micromètres. Une couche minérale **31** épaisse d'environ 0,1 à 0,2 micromètre, constituée d'oxyde ou de nitrure de silicium, ou silicium amorphe, est ensuite déposée en surface, et définie par gravure selon au moins un motif par microsite, de faible extension, qui intercepte localement le parcours des parois **4A.** La disposition dans les angles communs à quatre microsites des motifs **31,** de manière à former un polygone commun à quatre microsites comme suggéré par la figure 5A (en haut à gauche), est avantageuse au sens où les structures qui résulteront de cette description perturbent le moins possible la qualité du produit fini. Il est clair cependant que d'autres dispositions sont également valables.

Une nouvelle couche planarisante **32** est déposée, essentiellement de même nature que les couches **30** et **12,** avec une épaisseur typiquement de l'ordre de 0,1 à 0,2 micromètres, et un motif **4B** en forme de réseau croisé de rainures est alors formé par lithographie et gravure des couches **32, 31, 30** (en bas à gauche sur la figure 5A) jusqu'à déboucher sur le sommet des structures **4A.** La largeur et le motif des rainures est essentiellement superposable à la géométrie du motif **4A.**

Une couche minérale **33,** essentiellement transparente au rayonnement à détecter est déposée sur l'ensemble de manière à former un remplissage des rainures **4B,** lesquelles forment la partie supérieure **4B** des cloisons latérales **4** de microcapsules. Le matériau **33** est préférentiellement constitué de silicium amorphe, ou un alliage amorphe de silicium et de germanium, selon une épaisseur adaptée au remplissage des rainures **4B,** c'est-à-dire 0,5 à 1 micromètre typiquement. La gravure des rainures **4B** est éventuellement facilitée par l'usage d'une couche intermédiaire relativement fine, par exemple de 0,1 à 0,3 micromètre d'épaisseur de manière à former un contre-masquage (« *hard mask* ») de même nature que la couche **33,** mais déposée avant lithographie des rainures **4B,** selon l'usage du métier.

Des perforations **34** inscrites à l'intérieur des motifs **31** résiduels (c'est-à-dire en dehors des rainures **4B)** sont ensuite pratiquées par gravure de la couche **33,** selon la figure 5A, en bas à droite.

Il convient à ce point d'éliminer toutes les couches sacrificielles organiques internes aux microcapsules **12, 30, 32** à l'aide d'un plasma d'oxygène par exemple. Les ouvertures **34** fonctionnent comme évents de pénétration des espèces oxydantes et d'évacuation des sous-produits de gravure, selon une technique connue. Lorsque ces matériaux sont intégralement éliminés jusqu'au centre des microsites, l'ensemble est optionnellement pré-dégazé sous vide pendant un temps suffisant, par exemple une à quelques heures, à une température compatible avec les matériaux en place, de l'ordre typiquement de 200 à 400°C, puis les microcapsules sont hermétiquement scellées à l'aide du dépôt d'une ou plusieurs couches **35** transparentes au rayonnement à détecter, obtenues typiquement par voie physique, et de préférence par évaporation thermique. Cette technique est connue de l'homme du métier. Les matériaux utilisés sont préférentiellement, dans le cadre de la détection thermique entre 8 et 14 micromètres de longueur d'onde, le silicium, les alliages de silicium et de germanium, le sulfure de zinc. Ils peuvent être arrangés selon une structure multicouche avantageusement adaptée à l'optimisation de la transparence du capot fenêtre **33, 35.** Il n'est pas utile ici de détailler l'empilement en question, lequel cumule habituellement plusieurs microns d'épaisseur totale, ce qui est largement suffisant pour obturer de manière hermétique les ouvertures **34,** et ce faisant sceller sous vide les microcapsules, pour le cas habituel où une pression interne minimale serait recherchée.

Le scellement hermétique des microcapsules peut aussi, comme cela est connu, être formé par dépôt d'une couche non constitutive des fenêtres transparentes **5,** avant dépôt de la ou des couches **35.** Cette couche de scellement peut être opaque, et par exemple être formée d'un métal tel que l'aluminium, obtenu de préférence par évaporation. Dans ce cas cette couche doit ensuite être éliminée des zones optiques, avant dépôt de l'ensemble **35,** typiquement selon un motif identique aux éléments **31,** à l'aide d'un masque et d'une opération de gravure supplémentaire. Cette couche est hermétiquement solidaire de la fenêtre **5** et de l'élément **31.**

Selon une technique connue, il est également avantageux d'inscrire à l'intérieur des microcapsules au moins un matériau apte à capter les molécules résiduelles de gaz piégées dans les microcapsules, et par exemple du titane, lequel peut être par exemple le, ou un des matériaux constitutifs du réflecteur **11.** Ce matériau remplit alors la fonction de getter.

Il est possible aussi à cette étape de scellement hermétique, de prévoir une pression partielle d'un gaz à faible conductivité thermique, tel l'argon, le krypton, le xénon, comme cela est connu en soi. Ces gaz n'interfèrent pas avec les matériaux getter qui continuent dans ces conditions de jouer leur rôle vis-à-vis des gaz atmosphériques (oxygène, azote), les résidus organiques volatils, et l'hydrogène, qu'il convient de maintenir au plus bas niveau dans les microcavités.

La structure complète ainsi formée se différencie des structures selon l'art antérieur par le fait que les bras soutenant les membranes **2** ne sont plus limités en longueur par la formation des structures d'ancrage **3** à l'intérieur des microsites, et par l'amélioration sensible du facteur de remplissage de l'espace disponible par les membranes sensibles, du fait de la disparition par construction des dites structures d'ancrage. Il en résulte une sensibilité proche de celle procurée par les structures traditionnelles dépourvues de microcapsules, même pour des imageurs thermiques dessinés à des pas très réduits, et qui présentent simultanément l'avantage de ne pas nécessiter de processus d'intégration hermétique ultérieure dans un boîtier muni d'une fenêtre transparente.

Une disposition complémentaire avantageuse est maintenant décrite en relation avec les figures 6A à 6D.

A la suite de l'étape de dépôt de la couche **31,** on poursuit par le dépôt d'une couche d'aluminium **36** (ou tout autre matériau dont les caractères technologiques permettent le développement qui suit) de 0,1 à 0,2 micromètre d'épaisseur, laquelle est gravée à la suite de la couche **31** selon le même motif déjà décrit. Cette étape correspond à la partie en haut à gauche de la figure 6A.

La couche sacrificielle **32** est alors déposée, mais selon une épaisseur de l'ordre de 1 à 2 micromètres. Cette couche **32** est ensuite enlevée localement par gravure au voisinage des motifs **31** d'une part, et des motifs **4A** d'autre part, comme exemplifié sur la figure 6A. La marge de la couche **32** est formée selon une pente à la base de l'ordre de 30 à 45°. Ce résultat est obtenu selon une technique connue, telle qu'un refluage thermique (*resist reflow* en anglais) du masque lithographique avant gravure de la couche **32.**

La figure 6B suppose un profil régulier, mais un profil plus ou moins arrondi est également parfaitement adéquat. La gravure de la couche **32** s'arrête en surface de la couche **36** d'une part, et dans l'épaisseur des couches **30** et **32** d'autre part, sans criticité particulière. Cette étape est schématisée sur la partie en bas à gauche de la figure 6A.

Le processus se poursuit par la formation des rainures **4B**. A cet effet les couches **32** et **30** sont d'abord gravées, puis ensuite les couches **30** (s'il en subsiste une épaisseur partielle) et **36** jusqu'à découvrir les parois **4A** en fond de rainure. Les formations **4B** et la base du capot fenêtre est alors obtenue par dépôt de la couche **33.**

Les ouvertures **34,** inscrites à l'intérieur des motifs formés par la couche **36,** sont gravées à travers la couche **33,** comme déjà indiqué, la gravure s'arrête sur la couche **36.** Ce point est représenté sur la figure 6A (en bas à droite). La couche **36** est ensuite gravée latéralement, voire complètement éliminée de manière isotrope, typiquement par gravure humide, de manière à donner accès à la couche **32.**

La figure 6C précède l'opération suivante, lors de laquelle toutes les couches sacrificielles **12, 30, 32** sont éliminées à travers les évents **34** et l'espace libre laissé par la couche **36.** L'étape ultime de fermeture hermétique par dépôt physique sous vide a été décrite précédemment, est schématisée sur les figures 6A (en haut à droite) et 6D.

Le premier résultat de ce processus est la formation de capots fenêtres transparents, dont la périphérie présente des facettes inclinées vers le substrat, ou en forme arrondie, plongeant vers les surfaces d'appui **4A,** sans changement majeur des caractéristiques optiques en termes d'empilement et d'épaisseurs, ce qui produit au premier ordre sur chaque microsite, une structure optique équivalente à une micro lentille, c'est-à-dire dont la fonction est de dévier les rayons incidents au voisinage des frontières entre microsites, vers l'une ou l'autre des cavités adjacentes, où ils seront finalement absorbés par les membranes sensibles. Sans cette disposition, ces rayons seraient destinés à absorption ou diffusion sur les cloisons **4,** c'est à dire perdus en termes de formation d'image. Cet effet est schématisé par les flèches pointillées sur la figure 6D. Le résultat est un gain additionnel sur la sensibilité des sites de détection individuels.

Un autre résultat avantageux en termes de processus, est la facilitation du procédé de gravure, et donc aussi de remplissage, des rainures **4B,** car l'épaisseur résiduelle de la couche **30** à graver jusqu'à découverte des structures **4A** s'en trouve sensiblement diminuée. En fait, il est possible d'ajuster conjointement l'épaisseur des couches **30** et **32,** en relation avec la profondeur de la marge (facette) inclinée ou arrondie souhaitée, de manière à optimiser l'ensemble des procédés et la géométrie finale résultante. La profondeur des rainures **4B** peut être réduite par exemple à 0,5 micromètre, voire moins, sans difficultés, par l'usage d'une couche **30** arbitrairement fine.

En addition, l'épaisseur de la couche **33** est avantageusement adaptée au remplissage intégral des rainures **4B,** c'est-à-dire selon une épaisseur supérieure à la demi-largeur des rainures, de manière à ce que les flancs des motifs diffractifs formés par la couche (plus généralement, l'ensemble des couches) **35** soient jointifs (ne présentent pas de partie proche de la verticale), de manière à séparer les faisceaux lumineux incidents entre deux microsites adjacents sans perte intermédiaire. Ce résultat peut être complété par l'usage d'au moins une couche obtenue par CVD lors de la formation de la couche **35,** par exemple en mettant en œuvre du silicium, du germanium ou alliage intermédiaire obtenu par CVD. Cette disposition permet de plus de sécuriser l'herméticité des microcavités, une fois l'obturation des ouvertures **34** obtenue.

Il est maintenant décrit une série de modes particuliers de réalisation, destinés à conférer des caractères électro-optiques différents à tout ou une partie des microsites, au moyen de modifications au moins locales de la nature et/ou de la constitution des capots fenêtres individuels formés selon l'invention.

Selon un mode particulier de réalisation, la série de couches constitutives du capot fenêtre **5** d'une partie des microsites comprend une couche opaque sur tout le spectre infrarouge, s'étendant essentiellement sur toute la surface desdits microsites, essentiellement continue, typiquement métallique. Une telle couche est par exemple déjà mise en œuvre lors de l'opération de scellement des microcapsules, comme il a été précédemment indiqué. Il suffit dans ce cas de préserver cette couche sur les sites contenant un micro-détecteur qu'il est nécessaire ou avantageux de rendre « aveugle », à tout le moins essentiellement insensible au rayonnement de scène. Dans ce cas, cette couche additionnelle est constitutive de la « fenêtre » sur les microsites concernés, laquelle est alors mieux décrite par le terme conjoint « capot » car elle acquiert de fait la fonction d'écran optique. Si ladite couche métallique n'est pas requise lors du scellement, elle peut être aisément déposée de manière additionnelle, puis gravée sur les sites optiquement sensibles, avant ou après la formation de la couche **35.**

Le résultat avantageux est typiquement la formation, au prix d'une complexification très limitée, de structures bolométriques particulières insensibles au rayonnement de scène, dites de référence ou de compensation, habituellement nécessaires à la formation d'un signal épuré de mode commun, comme il est bien connu dans le domaine. Ces structures sont habituellement disposées en marge ou périphérie des surfaces matricielles sensibles, et ordinairement fort complexes à élaborer en dehors du cadre de l'invention (en l'absence de microcapsules).

Selon un autre mode particulier de réalisation de l'invention, une partie au moins des microsites comporte un réseau de bandes conductrices de l'électricité parallèles, formées dans ou sur la fenêtre **5** desdits microsites, s'étendant essentiellement sur toute la surface desdits microsites, dont le pas de répétition est inférieur aux longueurs d'onde à détecter. Par « inférieur », on entend au maximum de l'ordre de λmin/3.

Il est obtenu de cette manière un filtrage de polarisation du rayonnement incident, dont l'effet est d'affaiblir très substantiellement la composante dudit rayonnement orthogonale au réseau conducteur, la composante parallèle étant essentiellement transmise par la fenêtre **5.** L'homme du métier sait conférer à la membrane sensible disposée derrière une telle fenêtre une absorption optique optimisée pour un tel rayonnement polarisé, ou former au contraire, selon le but recherché, une membrane pratiquement insensible à la polarisation. Les éléments fournis par exemple dans le document FR 2 752 299 (US 5 912 464) sont pertinents dans ce domaine.

Un tel détecteur peut par exemple être utilisé pour exacerber, ou au contraire affaiblir le rayonnement des éléments de scène qui parviennent sur le plan focal après une réflexion sur un plan grossièrement parallèle à l'orientation du réseau métallique (réflexion d'objets chauds sur le sol par exemple).

La construction par ce moyen sur la même matrice d'une part, de microsites dotés d'une sensibilité préférentielle dans une direction de polarisation, et d'autre part, de microsites de sensibilité préférentielle selon l'orientation orthogonale, fournit un détecteur qui propose deux sous-images typiquement simultanées, par exemple entrelacées, des composantes « horizontale » et « verticale » du rayonnement de scène. Une information plus riche sur la scène observée est ainsi obtenue.

Selon un autre mode particulier de réalisation de l'invention, une partie au moins des microsites comporte un réseau de motifs conducteurs, formés dans ou sur la fenêtre **5** et s'étendant essentiellement sur toute la surface desdits microsites, dont le pas de répétition est de l'ordre de grandeur de la longueur d'onde préférentielle λp à détecter. Par « ordre de grandeur » on entend de l'ordre de λp à λp/2. En d'autres termes, le pas de répétition est compris entre λp et λp/2.

Par « motif élémentaire » on entend le motif le plus petit qui produit le réseau diffractif complet par réplication périodique selon deux directions (non nécessairement orthogonales) dans le plan parallèle au plan focal. Ledit motif diffractif élémentaire peut être un élément linéaire, un anneau, une croix, un disque, ces exemples sont fournis de manière non limitative.

Il est obtenu de cette manière une modulation de la sensibilité du détecteur selon l'angle d'incidence du rayonnement, par effet de diffraction sur le réseau de motifs. Cet effet peut être exploité par exemple pour exacerber ou au contraire atténuer la sensibilité du détecteur, en fonction de l'angle sous lequel apparait un élément de scène par rapport à l'axe optique du système dans lequel le détecteur est intégré.

La formation de ces filtres polariseurs ou diffractifs dans la constitution des fenêtres 5 est obtenue selon les mêmes techniques que précédemment développées pour la formation d'écrans opaques, moyennant le dessin approprié du masque de définition de la couche métallique. De préférence, la largeur des bandes conductrices sera choisie sensiblement plus faible que le pas de répétition. De même, la surface opaque du motif élémentaire sera choisie nettement inférieure au produit des pas de répétition dans les deux directions de réplication dudit motif élémentaire, de manière à ne pas affaiblir la sensibilité du micro-détecteur disposé en regard de la fenêtre munie d'un tel réseau.

Selon un autre mode particulier de réalisation de l'invention, la série de couches de la fenêtre **5** d'une partie des microsites comporte au moins une couche transparente dans la bande spectrale d'intérêt, différente en termes d'épaisseur et/ou de nature par rapport à la série de couches de la fenêtre **5** d'une autre partie des microsites, de telle manière à conférer une sensibilité spectrale préférentielle différente respectivement à chaque partie.

En d'autres termes, ce mode particulier de réalisation fournit (au moins) deux catégories de microsites disposés sur la même rétine, respectivement plus sensibles sur (au moins) deux parties de la bande spectrale d'intérêt commune, respectivement autour de deux longueurs d'onde préférentielles λp1 et λp2, en vertu des spectres de transmission différents des fenêtres **5** formées respectivement en regard de chaque micro-détecteur Il n'est pas nécessaire que ces deux spectres de transmission soient disjoints, ce qui n'est pas réalisable au moyen d'un faible nombre de couches constitutives de la fenêtre **5.** Ce caractère permet d'obtenir par exemple, au moyen du signal fourni par au moins deux microsites voisins, une information à partir de laquelle il est possible de discriminer la température de l'émissivité d'un objet particulier de la scène observée.

Les détails de réalisation ne peuvent être fournis de manière détaillée, dans la mesure où le spectre de transmission optique des systèmes multicouches dépend très rapidement des épaisseurs et indices respectifs de chaque couche. Cependant, l'homme de métier dispose des connaissances et techniques adéquates pour exploiter avantageusement ce caractère, et à l'aide d'une ou deux couches différentes pour l'élaboration respectivement de chaque catégorie de sites sensibles. Bien entendu, comme précédemment, la ou les couches différentes doivent être conservées ou éliminées localement selon la réponse spectrale attendue de chaque microsite, au moyen d'un ou des masques adéquats et techniques de mise en œuvre associées connues.

Il sera par exemple obtenu une réponse renforcée entre 8 et 10 micromètres, et déprimée au-delà de 10 micromètres pour une partie des microsites, et inversement pour l'autre partie des microsites. La formation de rétines dites bi-spectrales sur l'infrarouge moyen (entre 3 et 5 micromètres) et long (entre 8 et 14 micromètres) est possible également, sans que cela pose de contraintes sur la transparence « large bande » des fenêtres, comme c'est le cas pour les détecteurs intégrés en boîtier selon la technique traditionnelle, où la fenêtre ne peut être que commune à tous les points sensibles de la matrice, puisque disposée loin du plan focal.

Il convient d'apprécier que ce mode de réalisation offre de manière relativement simple la possibilité de former un imageur bi-spectral, voire multi spectral, dont la distribution spatiale de sensibilité (damier ou lignes interlacées par exemple) n'est définie que par le « design » du ou des masques qui déterminent la conservation ou l'élimination des couches différentes entre les diverses zones (parties) de la rétine sensible, appliqués en toute fin du processus d'élaboration.

On a de fait, illustré en relation avec la figure 7 un tel détecteur à sensibilité différentielle, respectivement autour de deux longueurs d'onde préférentielles λp1 et λp2. Dans l'exemple ainsi décrit, la fonction passe haut dont il est discuté plus loin, en l'espèce au-delà de λmin est commune à tous les microsites.

Selon un mode particulier de réalisation de l'invention, une première partie des microsites comporte une microcavité hermétique, alors qu'une seconde partie des microsites comporte une microcavité communiquant avec l'atmosphère externe. Ce caractère sera par exemple obtenu en masquant le dépôt de la couche **35** sur la seconde partie des microsites, ou en ne disposant pas la couche **31** en regard des ouvertures **34** desdits microsites.

Il est ainsi obtenu d'une part des micro-détecteurs sensibles au rayonnement pour la première partie de microsites, et des micro-détecteurs insensibles au rayonnement pour la seconde partie. Ces derniers peuvent être utilisés typiquement comme détecteurs de référence pour la formation d'un signal compensé de mode commun, ou plus généralement comme détecteurs sensibles à la pression externe au dispositif.

Selon un mode particulier de réalisation de l'invention, une première partie des microsites comporte une microcavité hermétique, alors qu'une seconde partie des microsites comporte des « microcapsules » formées en même temps et selon un processus essentiellement identique, mais entièrement comblées de matière. C'est à ce titre qu'on emploie le terme de « microcapsule » de préférence à « microcavité », cette dernière étant constituée par un volume limité par de la matière solide, mais vide de matière solide. Ce caractère sera immédiatement obtenu en ne disposant aucune ouverture **34** dans l'emprise desdits seconds microsites. De cette manière, les couches **12, 30, 32** de matériau sacrificiel restent en place lors de l'opération de retrait des couches sacrificielles, sans conséquences fonctionnelle autre que la formation d'un court-circuit thermique entre le micro-détecteur interne et le substrat.

Il est ainsi obtenu d'une part, des micro-détecteurs sensibles au rayonnement pour la première partie de microsites, et d'autre part, des micro-détecteurs insensibles au rayonnement et portés en permanence à la température du substrat (*heat sunk* en anglais), pour la seconde partie, sans qu'il soit besoin de former une couche opaque supplémentaire.

Les seconds microsites peuvent être utilisés typiquement comme détecteurs de référence pour la formation d'un signal compensé de mode commun, ou plus généralement comme détecteurs sensibles uniquement à la température du substrat, utilisables par exemple comme sondes de température (*temperature sensors*).

Il est maintenant décrit divers modes de mise en œuvre de l'invention en relation avec le filtrage passe haut de la réponse spectrale du détecteur, ou du dispositif (terme désignant ici un ensemble de niveau plus intégré) formé au moyen dudit détecteur.

Il est très habituel, en particulier pour les détecteurs opérant dans la bande de transparence atmosphérique entre 8 et 14 micromètres, d'intercaler un élément optique en amont du plan focal, dénommé filtre « passe haut », dont la fonction première est de bloquer les radiations de longueurs d'onde en dessous d'un seuil, habituellement fixé vers 7,5 à 7,7 micromètres lorsque la bande spectrale d'intérêt est l'infrarouge long, entre 8 et 14 micromètres.

Ce filtre passe haut est habituellement formé à l'aide d'un revêtement obtenu par dépôt multicouches, sur l'une des faces, ou généralement distribué sur les deux faces d'une lame épaisse en germanium ou silicium. Les deux faces de cette lame sont par ailleurs ordinairement pourvues d'un traitement antireflet transparent jusqu'à 12,5 à 16 micromètres typiquement, lui aussi obtenu à l'aide de dépôts multicouches. La lame fenêtre (ou fenêtre, selon l'acception usuelle du terme) est hermétiquement solidaire et constitutive de la face optiquement active de l'enceinte, ou boîtier traditionnel des détecteurs selon l'art antérieur. Le gabarit global de transmission de cette fenêtre définit de fait, pour les détecteurs bolométriques, la « bande spectrale d'intérêt », ou « rayonnement d'intérêt » du détecteur ou dispositif intégrant ledit détecteur.

Une première manière de mettre en œuvre le détecteur selon l'invention dans ces conditions préférentielles de filtrage passe haut, est de l'intégrer dans un boîtier pourvu d'une fenêtre traditionnelle telle que précédemment décrite. L'intérêt d'un tel assemblage tient d'une part au fait que le gabarit de transparence (la bande spectrale d'intérêt) est défini par la fenêtre du boîtier. Ainsi, des gabarits de transmission très contraignants sont accessibles au moyen d'un très grand nombre de couches, selon des modes de fabrication bien connus et maitrisés. D'autre part, le besoin d'herméticité dudit boîtier est écarté, ou à tout le moins nettement relâché, ce qui représente une économie de moyens et de rendement de fabrication au niveau du boîtier final non négligeable.

Il est par ailleurs avantageux dans ces conditions d'intégration, de prévoir la formation d'une atmosphère à pression moyenne, par exemple comprise entre 10 mbar et 2 bar, de gaz à faible diffusivité, tel que Ar, Kr, Xe dans le boîtier, de manière à optimiser la durée de vie du détecteur selon l'invention qui y est intégré. De cette manière, l'effet d'éventuels phénomènes de perméation à long terme, voire de microfissures dans la constitution des fenêtres 5, qui pourraient limiter l'herméticité des microcapsules, se trouve pour l'essentiel corrigé. Cependant, il est clair que le coût engendré par l'usage d'un tel boîtier muni d'une fenêtre complexe est conséquent, en sus de la légère perte de performance liée à la transparence partielle de la fenêtre additionnelle dans la bande spectrale d'intérêt.

Une seconde manière de mise en œuvre de l'invention avec blocage des courtes longueurs d'onde, consiste en la formation, dans ou sur la fenêtre **5** d'une partie au moins des microsites, d'au moins une couche qui confère directement à ladite fenêtre **5** un caractère de filtre « passe haut » en termes de transmission spectrale.

Cette couche particulière peut être déposée avantageusement en toute fin de processus, en surface de la fenêtre, de manière à autoriser la mise en œuvre de matériaux efficaces mais qui ne supporteraient pas des températures même très limitées, par exemple au delà de 150°C, puisque le processus de fabrication du détecteur est alors terminé.

Avantageusement, cette couche est formée d'un matériau semi-conducteur dont le « gap optique » est adapté à la gamme de rayonnements pour lequel le détecteur est destiné. Les longueurs d'onde correspondant aux énergies supérieures audit « gap optique » seront très efficacement bloquées par l'effet des transitions photo-électroniques directes dans le matériau. Par exemple, le composé binaire « III-V » InSb produit une coupure vers 7,3 micromètres, et le composé binaire « III-V » InAs une coupure vers 4 micromètres. Les alliages « III-V » ternaires tels que In₍₁₋ₓ₎AlₓSb ou In₍₁₋ₓ₎AlₓAs, dans lesquels 0 ≤ x ≤ 1, procurent un ajustement de coupure entre l'infrarouge moyen et long selon le choix de la composition x. De même, le choix de la composition x d'un matériau tel que le ternaire « II-VI » Hg_{(1-y)}Cd_{y}Te, dans lesquels 0,2 ≤ y ≤ 0,6 permet d'ajuster le seuil de transparence depuis la bande visible jusqu'à typiquement 8 micromètres, la fenêtre **5** étant essentiellement opaque en dessous dudit seuil. Le choix x voisin de 0,4 produit une coupure au voisinage de 3 micromètres, et le choix x voisin de 0,2 produit un seuil de coupure ajustable vers 7 - 8 micromètres, bien adapté à la détection selon l'invention dans l'infrarouge long. On peut enfin citer aussi le sulfure de plomb PbS pour produire une coupure vers 3 micromètre. Ces exemples sont fournis à titre non limitatif.

Pour obtenir l'effet recherché, il n'est pas nécessaire d'obtenir un haut niveau de pureté ou de cristallinité. Les méthodes habituelles de dépôt en couches minces de ces matériaux, par exemple appliquées pour obtenir 0,5 à 2 micromètres d'épaisseur, sont adaptées au but recherché, et il n'est nul besoin de les décrire.

En dessous de 1,8 micromètre de longueur d'onde, il n'y a pas besoin de filtrer le spectre radiatif dans la mesure où les systèmes de détection ou imagerie infrarouge sont ordinairement pourvus d'une optique en germanium, lequel est opaque aux longueurs d'onde inférieures. On obtient ainsi directement le filtrage passe haut (en longueur d'onde) du spectre radiatif incident sans qu'il soit besoin d'intercaler une fenêtre supplémentaire en amont du détecteur dans le chemin optique du système.

Selon l'invention, il est aussi proposé la formation d'un premier filtre passe haut selon un premier seuil de transmission sur une première partie des microsites, et d'un second (ou plus) filtre passe haut selon un second seuil de transmission sur une seconde (ou plus) partie des microsites. Ce résultat est obtenu au moyen de la sélection du matériau constitutif de la couche « passe haut » mise en œuvre respectivement sur chaque microsite, par exemple un choix différent parmi les matériaux précédemment indiqués, ou la superposition d'une couche d'un premier matériau passe haut sur une partie des microsites, et de deux couches respectivement de matériaux passe haut différents sur une autre partie des microsites. Il est ainsi obtenu au moyen du filtrage de coupure du rayonnement incident, en conjonction, ou de manière alternative à la formation de l'anti reflet distribué précédemment décrit (destiné à produire une sensibilité préférentielle autour des longueurs d'onde λp1 et λp2), une distribution de sensibilité spectrale du micro-détecteur, selon le microsite considéré.

En d'autres termes, dans ce mode particulier, la bande spectrale d'intérêt du détecteur est définie, du côté des courtes longueurs d'onde, par la coupure la plus basse, et la partie du spectre comprise entre les deux coupures n'est sensible que par une partie des microsites.

Selon encore un autre mode de réalisation, au moins une partie des microsites comporte une fenêtre **5** dont au moins une couche présente une transparence variable en fonction du flux électromagnétique incident. Plus précisément, une couche particulière dont la transparence diminue rapidement au-delà d'un seuil de puissance radiative caractéristique du matériau, peut être mise en œuvre.

Une telle couche est par exemple obtenue à partir de matériaux dits « non linéaires » dans les termes de métier, tels que InSb, In₍₁₋ₓ₎AlₓSb, In₍₁₋ₓ₎AlₓAs, dans lesquels 0≤ x ≤ 1 ; Hg_{(1-y)}Cd_{y}Te, dans lesquels 0,2≤ y ≤ 0,6, et les oxydes de vanadium (identifiés par la formule générique VOx selon l'usage du métier) et mis en œuvre sous forme de film mince de 0,5 à 2 micromètres d'épaisseur, selon les techniques usuelles du domaine.

Il est ainsi obtenu une protection au moins partielle, mais très avantageusement individuelle (pixellique) des éléments bolométriques sensibles disposés à l'intérieur de la microcapsule, au cas où un flux radiatif intense en provenance typiquement d'une source de scène à température très élevée serait projeté sur le plan focal du détecteur (par l'observation accidentelle du soleil par exemple). Une telle source est en effet susceptible de produire une altération durable, voire définitive des caractéristiques du ou des micro-détecteur(s) concerné(s).

Du fait que cette couche particulière « de protection » est disposée pratiquement au niveau du plan focal, l'énergie incidente s'y trouve pratiquement aussi concentrée qu'au niveau du détecteur lui-même, ce qui en maximalise l'efficacité par rapport au flux reçu par le détecteur. Il convient d'apprécier que la fonctionnalité du dispositif, en termes de permanence de disponibilité de l'image pour l'utilisateur, est maintenue pendant les périodes éventuelles de forte irradiation. En effet, les techniques usuelles du domaine conduisent au défaut notoire pour l'utilisateur de perte d'image, soit localement, par suite de la saturation du signal issu des points surexposés, soit complètement, du fait de la fermeture automatique de l'obturateur (*shutter*) après détection d'une scène réputée trop intensément émissive, si le système est équipé d'un tel arrangement automatique.

## Revendications

1. Détecteur de rayonnement infrarouge destiné à fonctionner autour d'une longueur d'onde préférentielle λp comprise dans une bande spectrale d'intérêt définie entre λmin et λmax, constitué d'une pluralité de microsites de détection élémentaires comprenant chacun un micro-détecteur muni d'une membrane (2) sensible au rayonnement au moins dans la bande spectrale d'intérêt, et reçu chacun dans une microcavité ou microcapsule définie par un substrat (1), par une paroi supérieure (5) faisant fonction de fenêtre transparente audit rayonnement dans la bande spectrale d'intérêt pour une partie au moins de ladite pluralité de microsites, et par des cloisons latérales (4), ladite membrane (2) étant suspendue au dessus du substrat (1) au moyen d'au moins deux bras de soutien (6) comportant une couche (17) électriquement conductrice, ***caractérisé :***
• **en ce que** les extrémités desdits bras (6) sont ancrées dans les cloisons latérales (4) ;
• **en ce que** les cloisons latérales (4) définissant lesdites microcavités ou microcapsules sont constituées de deux parties intimement jointes :
- une première partie inférieure (4A), adhérente au substrat (1), formant soubassements mitoyens des cloisons périphériques à chaque microsite de détection, et comprenant localement des connexions verticales conductrices de l'électricité en continuité électrique avec la couche électriquement conductrice (17) des bras (6) ;
- une seconde partie (4B), dont la base est superposée et solidairement jointe au sommet de ladite première partie (4A) sur la périphérie de chaque microcapsule, et supportant la paroi supérieure ou fenêtre (5), laquelle est essentiellement parallèle au substrat ;
• et **en ce que** la continuité électrique entre les au moins deux bras (6) et le substrat (1) est réalisée par conduction s'étendant transversalement par rapport à l'axe desdits bras au niveau du plan de jonction entre les parties (4A) et (4B) des parois latérales jusqu'à aboutir à un élément de connectique verticale (16) en conduction électrique avec ledit substrat.

2. Détecteur de rayonnement infrarouge selon la revendication 1, ***caractérisé* en ce qu'**une partie au moins des microcavités est hermétique.

3. Détecteur de rayonnement infrarouge selon la revendication 2, ***caractérisé* en ce que** les microcavités hermétiques contiennent de l'argon, du krypton ou du xénon.

4. Détecteur de rayonnement infrarouge selon l'une des revendications 1 à 3, ***caractérisé* en ce que** les ancrages et les connexions électriques des extrémités des au moins deux bras de soutien (6) comportant une couche (17) électriquement conductrice des membranes sensibles (2) sont formés aux interfaces entre les deux parties (4A) et (4B) constitutives des cloisons latérales (4).

5. Détecteur de rayonnement infrarouge selon l'une des revendications 1 à 4, ***caractérisé* en ce qu'**il est exempt de toute structure d'ancrage des bras de soutien (6) des membranes sensibles (2) autre que les cloisons latérales définissant les microcapsules.

6. Détecteur de rayonnement infrarouge selon l'une des revendications 1 à 5, ***caractérisé* en ce que** la paroi supérieure ou fenêtre (5) présente au voisinage des cloisons latérales (4) des facettes périphériques inclinées en direction du substrat (1) ou de profil arrondi, aptes à dévier le rayonnement incident au voisinage des frontières entre deux microsites vers l'une ou l'autre des microcavités adjacentes.

7. Détecteur de rayonnement infrarouge selon l'une des revendications 1 à 6, ***caractérisé* en ce que** le substrat (1) est revêtu d'une couche (11) faisant fonction de réflecteur du rayonnement incident en direction des membranes sensibles (2).

8. Détecteur de rayonnement infrarouge selon la revendication 7, ***caractérisé* en ce que** le réflecteur (11) est constitué en totalité ou en partie d'un matériau apte à capter les molécules résiduelles de gaz piégées dans les microcavités ou getter, avantageusement constitué par du titane.

9. Détecteur de rayonnement infrarouge selon l'une des revendications 1 à 8, ***caractérisé* en ce que** le scellement hermétique des microcavités est formé de matériaux adhérents à, ou constitutifs de la paroi supérieure ou fenêtre (5) et qui reposent solidairement sur des éléments (31) disposés localement en dessous des fenêtres (5) et ancrés latéralement dans la partie supérieure (4B) des cloisons latérales (4).

10. Détecteur de rayonnement infrarouge selon l'une quelconque des revendications 1 à 9, ***caractérisé* en ce que** les micro-détecteurs sont constitués de microbolomètres, et **en ce que** la paroi supérieure ou fenêtre (5) est au moins en partie réalisée en un matériau choisi dans le groupe comprenant le silicium, les alliages de silicium et de germanium, le sulfure de zinc, en couche unitaire ou en multicouche.

11. Détecteur de rayonnement infrarouge selon la revendication 10, ***caractérisé* en ce que** la fenêtre (5) d'une première partie des microsites comporte au moins une couche, essentiellement transparente dans la bande spectrale d'intérêt, différente par rapport à la fenêtre d'au moins une seconde partie des microsites, de telle manière à ce que la longueur d'onde préférentielle λp1 des micro-détecteurs de la première partie soit substantiellement différente de la longueur d'onde préférentielle λp2 de la au moins seconde partie.

12. Détecteur de rayonnement infrarouge selon l'une des revendications 10 et 11, ***caractérisé* en ce que** la fenêtre (5) d'une partie des microsites comporte une couche essentiellement continue, s'étendant essentiellement sur toute la surface desdits microsites, et opaque à tous les rayonnements du spectre infrarouge.

13. Détecteur de rayonnement infrarouge selon l'une des revendications 10 à 12, ***caractérisé* en ce que** la fenêtre (5) d'une partie au moins des microsites comporte un réseau de motifs conducteurs de l'électricité, couvrant essentiellement toute la surface desdits microsites.

14. Détecteur de rayonnement infrarouge selon la revendication 13, ***caractérisé* en ce que** ledit réseau est formé de bandes ou lignes parallèles disposées selon un pas de répétition inférieur à λmin/3.

15. Détecteur de rayonnement infrarouge selon la revendication 14, ***caractérisé* en ce que** la fenêtre (5) d'une première partie des microsites comporte un réseau formé selon une première direction, et **en ce que** la fenêtre (5) d'une seconde partie des microsites comporte un réseau formé selon la direction orthogonale à la direction du premier réseau.

16. Détecteur de rayonnement infrarouge selon la revendication 13, ***caractérisé* en ce que** ledit réseau est formé par la répétition, selon deux directions dans le plan parallèle au plan focal, et selon un pas de répétition compris entre λp et λp/2, d'un motif élémentaire de dimensions inférieures ou égale au pas de répétition.

17. Détecteur de rayonnement infrarouge selon l'une quelconque des revendications 12 à 16, ***caractérisé* en ce que** la couche opaque, les bandes parallèles ou les motifs élémentaires électriquement conducteurs sont un métal.

18. Détecteur de rayonnement infrarouge selon l'une quelconque des revendications 1 à 17, ***caractérisé* en ce que** la microcapsule d'une partie des microsites est remplie de matière solide.

19. Détecteur de rayonnement infrarouge selon l'une des revendications 10 à 18, ***caractérisé* en ce qu'**au moins une partie des microsites comporte une fenêtre (5) dont au moins une couche est constituée d'un matériau présentant un spectre de transmission de type passe haut.

20. Détecteur de rayonnement infrarouge selon la revendication 19, ***caractérisé* en ce que** le matériau est un semi-conducteur.

21. Détecteur de rayonnement infrarouge selon la revendication 20, ***caractérisé* en ce que** le semi-conducteur est choisi dans le groupe comprenant In₍₁₋ₓ₎AlₓAs, In₍₁₋ₓ₎AlₓSb, dans lesquels 0 ≤ x ≤ 1 ; Hg_{(1-y)}Cd_{y}Te, dans lequel 0,2 ≤ y ≤ 0,6 ; et PbS.

22. Détecteur de rayonnement infrarouge selon la revendication 20, ***caractérisé* en ce qu'**une première partie des microsites est pourvue d'un filtre passe haut selon une première longueur d'onde de coupure, et **en ce qu'**au moins une seconde partie des microsites est pourvue d'un filtre passe haut selon au moins une seconde longueur d'onde de coupure.

23. Détecteur de rayonnement infrarouge selon l'une des revendications 10 à 18, ***caractérisé* en ce qu'**au moins une partie des microsites comporte une fenêtre (5) dont au moins une couche est constituée d'un matériau à caractère de transparence variable en fonction du flux électromagnétique incident.

24. Détecteur de rayonnement infrarouge selon la revendication 23, ***caractérisé* en ce que** ledit matériau est choisi dans le groupe comprenant In₍₁₋ₓ₎AlₓSb, In₍₁₋ₓ₎AlₓAs, dans lesquels 0 ≤ x ≤ 1 ; Hg_{(1-y)}Cd_{y}Te, dans lequel 0,2 ≤ y ≤ 0,6 , et les oxydes de vanadium de formule générique VOx.

25. Dispositif pour la détection d'un rayonnement infrarouge destiné à fonctionner autour d'une longueur d'onde préférentielle λp comprise dans une bande spectrale d'intérêt définie entre λmin et λmax, comprenant :
- un boîtier hermétique muni d'une fenêtre sur l'une de ses faces, ladite fenêtre étant essentiellement transparente dans la bande spectrale d'intérêt, et essentiellement opaque en dessous d'une longueur d'onde dite de coupure ;
- un détecteur de rayonnement électromagnétique disposé à l'intérieur du boîtier en regard de ladite fenêtre ;
***caractérisé* en ce que** le détecteur est conforme à l'une quelconque des revendications 10 à 18, et **en ce que** l'atmosphère à l'intérieur du boîtier est constituée d'un gaz choisi parmi l'argon, le krypton et le xénon ou d'un mélange de ces gaz.

26. Dispositif pour la détection d'un rayonnement infrarouge selon la revendication 25, ***caractérisé* en ce que** la pression à l'intérieur du boîtier est comprise entre 10 mbar et 2 bar.

## Patentansprüche

1. Detektor für Infrarot-Strahlung, der dazu bestimmt ist, im Bereich einer bevorzugten Wellenlänge λp zu funktionieren, die in einem Spektralband mit definiertem Interesse zwischen λmin und λmax liegt, der aus einer Vielzahl von Elementar-Detektor-Mikrosites besteht, die jeweils einen Mikrodetektor umfassen, der mit einer Membran (2) versehen ist, die gegenüber der Strahlung zumindest im interessierenden Spektralband empfindlich ist und die jeweils in einem Mikrohohlraum oder einer Mikrokapsel aufgenommen werden, definiert durch ein Substrat (1), durch eine obere Wand (5), die wie ein für die Strahlung im interessierenden Spektralband transparentes Fenster wirkt, zumindest für einen Teil dieser Vielzahl von Mikrosites sowie durch seitliche Trennwände (4), wobei die Membran (2) mittels mindestens zwei Haltearmen (6) mit einer elektrisch leitenden Schicht (17) über dem Substrat (1) aufgehängt ist, ***dadurch gekennzeichnet:***
• **dass** die Enden dieser Arme (6) in den Seitenwänden (4) verankert sind;
• **dass** die Seitenwände (4), die diese Mikrohohlräume oder Mikrokapseln definieren, aus zwei eng verbundenen Teilen besteht:
- ein erster unterer Teil (4A), der an dem Substrat (1) haftet, und als angrenzender Unterbau an die peripheren Trennwände jedes Detektor - Microsite dient und lokal elektrisch leitende vertikale Verbindungen in elektrischer Verbindung mit der elektrisch leitenden Schicht (17) der Arme (6) aufweist;
- ein zweiter Teil (4B), dessen Basis darüber liegt mit dem Oberteil des genannten ersten Teils (4A) an der Peripherie jeder Mikrokapsel und fest verbunden ist und der die obere Wand oder das Fenster (5) trägt, das im Wesentlichen parallel zum Substrat ist;
• und dadurch dass die elektrisch Verbindung zwischen dem mindestens einen Arm (6) und dem Substrat (1) durch Konduktion ausgeführt wird, die quer, bezogen auf die Achse dieser Arme, in Höhe der Verbindungsebene zwischen den Teilen (4A) und (4B) der Seitenwände verläuft, bis sie in einem vertikalen Verbindungselement (16) mündet, das in elektrischer Verbindung mit diesem Substrat steht.

2. Detektor für Infrarot-Strahlung nach Anspruch 1, ***dadurch gekennzeichnet,* dass** mindestens ein Teil der Mikrohohlräume hermetisch ist.

3. Detektor für Infrarot-Strahlung nach Anspruch 2, ***dadurch gekennzeichnet,* dass** die hermetischen Mikrohohlräume Argon, Krypton oder Xenon enthalten.

4. Detektor für Infrarot-Strahlung nach Anspruch 1, ***dadurch gekennzeichnet,* dass** die Verankerungen und die elektrischen Verbindungen der mindestens zwei Haltearme (6), die eine elektrisch leitende Schicht (17) der empfindlichen Membrane (2) enthalten, an den Schnittstellen zwischen den beiden Teilen (4A) und (4B), aus denen die Seitenwände (4) bestehen, gebildet werden.

5. Detektor für Infrarot-Strahlung nach einem der Ansprüche 1 bis 4, ***dadurch gekennzeichnet,* dass** er von allen Verankerungsstrukturen der Haltearme (6) der empfindlichen Membrane (2) frei ist, außer den Seitenwänden, die die Mikrokapseln definieren.

6. Detektor für Infrarot-Strahlung nach einem der Ansprüche 1 bis 5, ***dadurch gekennzeichnet,* dass** die obere Wand des Fensters (5) in der Nähe der Seitenwände (4) periphere Facetten enthält, die in Richtung des Substrats (1) oder des abgerundeten Profils geneigt sind und die in der Lage sind, die einfallende Strahlung in der Nachbarschaft der Grenzen von zwei Mikrosites zum einen oder anderen benachbarten Mikrohohlraum abzuleiten.

7. Detektor für Infrarot-Strahlung nach einem der Ansprüche 1 bis 6, ***dadurch gekennzeichnet,* dass** das Substrat (1) mit einer Schicht (11) bedeckt ist, die als Reflektor für die in Richtung der empfindlichen Membrane (2) einfallende Strahlung dient.

8. Detektor für Infrarot-Strahlung nach Anspruch 1, ***dadurch gekennzeichnet,* dass** der Reflektor (11) insgesamt oder teilweise aus einem Material, das in der Lage ist, die restlichen Gasmoleküle, die in den Mikrohohlräumen oder Getter gefangen sind, aufzufangen und am besten aus Titan besteht.

9. Detektor für Infrarot-Strahlung nach einem der Ansprüche 1 bis 8, ***dadurch gekennzeichnet,* dass** die hermetische Abdichtung der Mikrohohlräume aus Material besteht, das an der oberen Wand oder dem Fenster (5) haftet oder diese bildet und das stabil auf Elementen (31) ruht, die lokal unterhalb der Fenster (5) angeordnet sind und seitlich im oberen Teil (4b) der Seitenwände (4) verankert sind.

10. Detektor für Infrarot-Strahlung gemäß einem der Ansprüche 1 bis 9, ***dadurch gekennzeichnet,* dass** die Mikrodetektoren aus Mikrobolometern bestehen und dass die obere Wand oder das Fenster (5) zumindest teilweise aus einem Material besteht, das aus der Gruppe ausgewählt wird, zu der Silizium, Silizium- und Germaniumlegierungen oder Zinksulfid gehören, in einer einzigen oder mehreren Schichten.

11. Detektor für Infrarot-Strahlung gemäß Anspruch 10, ***dadurch gekennzeichnet,* dass** das Fenster (5) eines ersten Teils der Mikrosites mindestens eine, im Wesentlichen im interessierenden Spektralband transparente, Schicht enthält, die sich vom Fenster mindestens eines zweiten Teils der Mikrosites unterscheidet, so dass die bevorzugte Wellenlänge λp1 der Mikrodetektoren des ersten Teils sich deutlich von der bevorzugten Wellenlänge λp2 des mindestens zweiten Teils unterscheidet.

12. Detektor für Infrarot-Strahlung nach einem der Ansprüche 10 und 11, ***dadurch gekennzeichnet,* dass** das Fenster (5) eines Teils der Mikrosites eine im Wesentlichen kontinuierliche Schicht enthält, die sich im Wesentlichen über die gesamte Oberfläche dieser Mikrosites erstreckt und die gegenüber allen Strahlungen des Infrarot-Spektrums opak ist.

13. Detektor für Infrarot-Strahlung nach einem der Ansprüche 10 bis 12, ***dadurch gekennzeichnet,* dass** das Fenster (5) mindestens eines Teils der Mikrosites ein Netz elektrisch leitender Muster enthält, das im Wesentlichen die gesamte Fläche dieser Mikrosites abdeckt.

14. Detektor für Infrarot-Strahlung nach Anspruch 1, ***dadurch gekennzeichnet,* dass** dieses Netz aus parallelen Streifen oder Linien besteht, die mit einem Wiederholungsabstand von unter λmin/3 gebildet wird.

15. Detektor für Infrarot-Strahlung nach Anspruch 14, ***dadurch gekennzeichnet,* dass** das Fenster (5) eines ersten Teils der Mikrosites ein Netz enthält, das nach einer ersten Richtung gebildet ist und dadurch dass das Fenster (5) eines zweiten Teils der Mikrosites ein Netz, das in einer Richtung quer zur Richtung des ersten Netzes gebildet ist, enthält.

16. Detektor für Infrarot-Strahlung nach Anspruch 13, ***dadurch gekennzeichnet, dass*** dieses Netz durch Wiederholung, in zwei Richtungen in einer Ebene parallel zur Brennebene und entsprechend einem Wiederholungsabstand zwischen λp unter λp/2, eines elementaren Musters gebildet wird, dessen Maße kleiner oder gleich dem Wiederholungsabstand ist.

17. Detektor für Infrarot-Strahlung nach einem der Ansprüche 12 bis 16, ***dadurch gekennzeichnet,* dass** die opake Schicht, die parallelen Streifen oder die elementaren Muster, die elektrisch leiten, aus einem Metall bestehen.

18. Detektor für Infrarot-Strahlung nach einem der Ansprüche 1 bis 8, ***dadurch gekennzeichnet,* dass** die Mikrokapsel eines Teils der Mikrosites mit festem Material gefüllt ist.

19. Detektor für Infrarot-Strahlung nach einem der Ansprüche 1 bis 8, ***dadurch gekennzeichnet,* dass** mindestens ein Teil der Mikrosites ein Fenster (5) enthält, bei dem mindestens eine Schicht aus einem Material besteht, dass ein Transmissionsspektrum vom Hochpass- Typ aufweist.

20. Detektor für Infrarot-Strahlung nach Anspruch 1, ***dadurch gekennzeichnet,* dass** es sich bei dem Material um einen Halbleiter handelt.

21. Detektor für Infrarot-Strahlung nach einem Anspruch 20, ***dadurch gekennzeichnet,* dass** das Halbleitermaterial aus der Gruppe ausgewählt wird, zu der In₍₁₋ₓ₎AlₓAs, In₍₁₋ₓ)AlₓSb, in denen 0 ≤ x ≤ 1 ; Hg_{(i-y})Cd_{y}Te, in denen 0,2 ≤ y ≤ 0,6 und PbS gehören.

22. Detektor für Infrarot-Strahlung nach Anspruch 20, ***dadurch gekennzeichnet,* dass** ein erster Teil der Mikrosites mit einem Hochpassfilter nach einer ersten Abschaltwellenlänge ausgerüstet ist und dass mindestens ein zweiter Teil der Mikrosites mit einem Hochpassfilter nach mindestens einer zweiten Abschaltwellenlänge ausgerüstet ist.

23. Detektor für Infrarot-Strahlung nach einem der Ansprüche 1 bis 8, ***dadurch gekennzeichnet,* dass** mindestens ein Teil der Mikrosites ein Fenster (5) enthält, bei dem mindestens eine Schicht aus einem Material besteht, das eine variable Transparenz in Abhängigkeit vom einfallenden elektromagnetischen Fluss enthält.

24. Detektor für Infrarot-Strahlung nach Anspruch 23, ***dadurch gekennzeichnet,* dass** dieses Material ausgewählt wird aus der Gruppe zu der In₍ᵢ₋ₓ₎AlₓSb, In₍ᵢ₋ₓ₎, AlₓAs, in denen 0 ≤ x ≤ 1 ; Hg_{(i-y)}Cd_{y}Te, in denen 0,2 ≤ y ≤ 0,6, sowie Vanadiumoxide mit der generischen Formel Vox gehören.

25. Vorrichtung zur Erkennung einer Infrarot-Strahlung, dazu bestimmt ist, im Bereich einer bevorzugten Wellenlänge λp zu funktionieren, die in einem Spektralband mit definiertem Interesse zwischen λmin und λmax liegen, umfassend:
- ein hermetisches Gehäuse, das mit einem Fenster auf einer der Seiten ausgerüstet ist, wobei dieses Fenster im Wesentlichen im interessierenden Spektralband transparent ist und im Wesentlichen unterhalb einer Wellenlänge opak ist, die als Abschaltwellenlänge bezeichnet wird;
- einen elektromagnetischen Strahlungsdetektor, der innerhalb des Gehäuses, gegenüber dieses Fensters angeordnet ist;
***dadurch gekennzeichnet,* dass** der Detektor einem der Ansprüche 10 bis 18 entspricht und dass die Atmosphäre innerhalb des Gehäuses aus einem Gas besteht, das aus Argon, Krypton und Xenon oder einer Mischung dieser Gase ausgewählt wird.

26. Vorrichtung zur Erkennung einer Infrarotstrahlung gemäß Anspruch 25, **dadurch gekennzeichnet, dass** der Druck innerhalb des Gehäuses zwischen 10 mbar und 2 bar liegt.

## Claims

1. An infrared radiation detector intended to operate around a preferred wavelength λp contained within a spectral band of interest that is defined between λmin and λmax, comprising a plurality of elementary detection micro-sites, each including a micro-detector provided with a membrane (2) that is sensitive to radiation at least in the spectral band of interest and each being provided in a micro-cavity or micro-capsule defined by a substrate (1), by an upper wall (5) used as a window that is transparent to said radiation in the spectral band of interest for at least some of said plurality of micro-sites and by side walls (4), said membrane (2) being suspended above substrate (1) by means of at least two support arms (6) that include an electrically conducting layer (17), ***characterised* :**
• **in that** the ends of said arms (6) are anchored in side walls (4) ;
• **in that** the side walls (4) that define said micro-cavities or micro-capsules consist of two intimately joined parts:
- a first lower part (4A) that adheres to substrate (1) and forms semi-detached bases of the peripheral walls at each detection micro-site and locally comprises electrically conducting vertical connections that ensure electrical continuity with the electrically conducting layer (17) of support arms (6);
- a second part (4B), the base of which is superposed on and physically attached to the top of said first part (4A) around the periphery of each micro-capsule and supports the upper wall or window (5) which is substantially parallel to the substrate;
• and **in that** electrical continuity between the at least two support arms (6) and the substrate (1) is obtained by conduction that extends transversely relative to the axis of said arms at the level of the bond line between the parts (4A) and (4B) of the side walls as far as a vertical connection element (16) which is in electrical conduction with said substrate.

2. The infrared radiation detector as claimed in claim 1, ***characterised* in that** at least some of the micro-cavities are hermetically sealed.

3. The infrared radiation detector as claimed in claim 2, ***characterised* in that** the hermetically sealed micro-cavities contain argon, krypton or xenon.

4. The infrared radiation detector as claimed in one of claims 1 to 3, ***characterised* in that** the anchoring points and electrical connections for the ends of the at least two support arms (6) comprising an electrically conducting layer (17) of sensitive membranes (2) are formed at the interfaces between the two parts (4A) and (4B) that constitute side walls (4).

5. The infrared radiation detector as claimed in either claim 1 to 4, ***characterised* in that** it is devoid of any structure for anchoring support arms (6) of sensitive membranes (2) other than the side walls that define the micro-capsules.

6. The infrared radiation detector as claimed in any of claims 1 to 5, ***characterised* in that** upper wall or window (5) has, in the vicinity of side walls (4), peripheral facets that slope towards substrate (1) or a rounded profile capable of deflecting incident radiation in the vicinity of the boundaries between two micro-sites towards either of the adjacent micro-cavities.

7. The infrared radiation detector as claimed in any of claims 1 to 6, ***characterised* in that** substrate (1) is covered with a layer (11) that acts as a reflector to reflect incident radiation towards sensitive membranes (2).

8. The infrared radiation detector as claimed in claim 7, ***characterised* in that** reflector (11) consists wholly or partly of a material capable of collecting residual gas molecules trapped in the micro-cavities or getter which advantageously consists of titanium.

9. The infrared radiation detector as claimed in any of claims 1 to 8, ***characterised* in that** the hermetic sealing of the micro-cavities is formed by materials that adhere to or are integral with the upper wall or window (5) and rest firmly on elements (31) that are arranged locally underneath windows (5) and are laterally anchored to upper part (4B) of side walls (4).

10. The infrared radiation detector as claimed in any of claims 1 to 9, ***characterised* in that** the micro-detectors consist of microbolometers and **in that** upper wall or window (5) is at least partly made of a material selected from the group comprising silicon, alloys of silicon and germanium or zinc sulphide, as a single layer or a multilayer.

11. The infrared radiation detector as claimed in claim 10, ***characterised* in that** window (5) of a first portion of the micro-sites comprises at least one layer that is essentially transparent in the spectral band of interest which is different compared to the window of at least a second portion of the micro-sites so that the preferred wavelength λp1 of the micro-detectors of the first portion is substantially different to the preferred wavelength λp2 of the at least second portion.

12. The infrared radiation detector as claimed in either claim 10 or 11, ***characterised* in that** window (5) of some of the micro-sites comprises a layer that is substantially continuous and extends substantially over the entire surface area of said micro-sites and is opaque to all the radiation in the infrared spectrum.

13. The infrared radiation detector as claimed in any of claims 10 to 12, ***characterised* in that** window (5) of at least some of the micro-sites comprises a grid of electrically conducting patterns that substantially cover the entire surface area of said micro-sites.

14. The infrared radiation detector as claimed in claim 13, ***characterised* in that** said grid is formed by parallel strips or lines arranged with a repetition pitch that is less than λmin/3.

15. The infrared radiation detector as claimed in claim 14, ***characterised* in that** window (5) of a first portion of the micro-sites comprises a grid formed in a first direction and **in that** window (5) of a second portion of the micro-sites comprises a grid formed in a direction that is at right angles to the direction of the first grid.

16. The infrared radiation detector as claimed in claim 13, ***characterised* in that** said grid is formed by repeating, in two directions in a plane parallel to the focal plane and with a repetition pitch of λp to λp/2, an elementary pattern having dimensions that are equal to or less than the repetition pitch.

17. The infrared radiation detector as claimed in any of claims 12 to 16, ***characterised* in that** the opaque layer, the parallel strips or electrically conducting elementary patterns are made of metal.

18. The infrared radiation detector as claimed in any of claims 1 to 17, ***characterised* in that** the micro-capsules of some of the micro-sites is filled with solid material.

19. The infrared radiation detector as claimed in any of claims 10 to 18, ***characterised* in that** at least some of the micro-sites comprise a window (5) whereof at least one layer consists of a material having a high-pass type transmission spectrum.

20. The infrared radiation detector as claimed in claim 19, ***characterised* in that** the material is a semiconductor.

21. The infrared radiation detector as claimed in claim 20, ***characterised* in that** the semiconductor is selected from the group comprising In₍₁₋ₓ₎AlₓAs, In₍₁₋ₓ₎AlₓSb in which 0≤ x ≤ 1; Hg_{(1-y)}Cd_{y}Te in which 0.2 ≤ y ≤ 0.6; and PbS.

22. The infrared radiation detector as claimed in claim 19, ***characterised* in that** a first portion of the micro-sites is provided with a high-pass filter having a first cut-off wavelength and **in that** at least a second portion of the micro-sites is provided with a high-pass filter having at least a second cut-off wavelength.

23. The infrared radiation detector as claimed in any of claims 10 to 18, ***characterised* in that** at least some of the micro-sites comprise a window (5) whereof at least one layer consists of a material having variable transparency as a function of the incident electromagnetic flux.

24. The infrared radiation detector as claimed in claim 23, ***characterised* in that** said material is selected from the group comprising In₍₁₋ₓ₎AlₓSb, In₍₁₋ₓ₎AlₓAs in which 0≤x≤1; Hg_{(1-y)}Cd_{y}Te in which 0.2 ≤ y ≤ 0.6 and vanadium oxides having the generic formula VOx.

25. A device for detecting infrared radiation designed to operate around a preferred wavelength λp contained in a spectral band of interest defined between λmin and λmax, comprising:
• a hermetically sealed package provided with a window on one of its faces, said window being substantially transparent in the spectral band of interest and substantially opaque below a cut-off wavelength;
• an electromagnetic radiation detector located inside a package facing said window;
***characterised* in that** the detector is as claimed in any of claims 10 to 18, and **in that** the atmosphere inside the package consists of a gas selected from the group comprising argon, krypton and xenon or a mixture thereof.

26. The device for detecting infrared radiation as claimed in claim 25, ***characterised* in that** the pressure inside the package is 10 mbar to 2 bar.
